(19) **Europäisches Patentamt / European Patent Office / Office européen des brevets**

(11) **EP 1 788 678 A1**

(12) **EUROPEAN PATENT APPLICATION**

(43) Date of publication:
 **23.05.2007 Bulletin 2007/21**

(51) Int Cl.:
 *H01S 5/40* (2006.01)   *H01S 5/14* (2006.01)

(21) Application number: **06255902.6**

(22) Date of filing: **17.11.2006**

(84) Designated Contracting States:
 **AT BE BG CH CY CZ DE DK EE ES FI FR GB GR HU IE IS IT LI LT LU LV MC NL PL PT RO SE SI SK TR**
 Designated Extension States:
 **AL BA HR MK YU**

(30) Priority: **18.11.2005 US 737925 P**

(71) Applicant: **JDS Uniphase Corporation**
 **Milpitas CA 95035 (US)**

(72) Inventors:
 • **Muendel, Martin H.**
  **Oakland**
  **California, 94611 (US)**
 • **Dougherty, David J.**
  **Mountain View**
  **California, 94043 (US)**
 • **Peters, Matthew Glenn**
  **Menlo Park**
  **California, 94025 (US)**
 • **Rossin, Victor**
  **Mountain View**
  **California, 94041 (US)**
 • **Sargent, Robert B.**
  **Santa Rosa**
  **California, 95404 (US)**
 • **Marabella, Len**
  **Santa Rosa**
  **California, 95403 (US)**
 • **Tai, Kuochou**
  **Fremont**
  **California, 94539 (US)**
 • **Acklin, Bruno**
  **Mountain View**
  **California, 94040 (US)**
 • **Wu, Yongan**
  **San Jose**
  **California, 95117 (US)**
 • **Dzurko, Kenneth M.**
  **Monte Sereno**
  **California, 95030 (US)**

(74) Representative: **McKechnie, Neil Henry et al**
 **Kennedys Patent Agency Limited**
 **185 St Vincent Street**
 **Glasgow G2 5QD (GB)**

(54) **High efficiency, wavelenght stabilized laser diode using arrayed waveguide gratings (AWG) and architecture for combining same with brightness conservation**

(57)   The invention relates to high power semiconductor lasers based on a laser diode array waveguide grating (DAWG;300) in which the wavelength is stabilized using an array waveguide grating (AWG;302) in an external cavity configuration. Another aspect of the present invention relates to techniques for efficiently coupling optical gain element arrays to an AWG. Another feature provides for the efficient and brightness-conserving combination of multiple high power DAWG lasers into a single output.

Fig. 3b

**Description**

**TECHNICAL FIELD**

The present invention relates to wavelength stabilized semiconductor laser sources in which array waveguide gratings (AWG) are used as the optical wavelength stabilizing element in an external cavity, in particular to broad-area (multimode) semiconductor laser diode arrays and , more particularly, to a system for scaling power to a 10 watt to kilowatt level into a single fiber output by combining outputs of multiple laser sources using wavelength and polarization multiplexing to conserve brightness.

**BACKGROUND OF THE INVENTION**

Semiconductor high power lasers are interesting as replacements of today's commercially available CW fiber lasers (FL's) for many reasons, among which compact size and high efficiency are among the most attractive. High-power single-mode fiber-coupled (FC) modules potentially have advantages of wavelength versatility (most FL's are based on Yb at 1050-1100nm), compactness, improved efficiency, and enhanced reliability due to the elimination of the double-clad fiber.

High-power multimode modules are of interest in less demanding applications, where output powers in the 100W range from a 25-100 micron core fiber would be adequate. They would have the added advantage of lifting the constraint of single-mode operation, making these devices smaller, lower cost, and easier to manufacture than their single-mode counterpart.

For applications demanding pulsed output or extremely high brightness, high-power modules can serve as a very cost-effective pump for Yb fiber lasers or disk lasers. One particular area of interest is a pump source for amplifying picosecond or femtosecond pulses in double-clad fiber, where the fiber length must be kept extremely short to mitigate pulse distortion, and therefore a very high brightness pump is required.

A narrow wavelength high brightness pump technology will improve the fiber laser efficiency in a number of ways. Firstly, tight wavelength control will allow pumping of the narrow 976 nm Ytterbium absorption line which has a better quantum defect and higher absorption than the broader 915nm line. Secondly, a high brightness source will enable pumping into a smaller diameter fiber. Conventional bars and single emitters, with relatively low brightness, require fiber with a large inner cladding (typically 400-600 microns), while a high-NA polymer outer clad fiber ends up having a much higher loss per unit length and very long (typically >50m). Thirdly, the combination of these improvements will translate to a shorter overall fiber length with lower overall absorption and scattering and lower threshold power requirements. Fourthly, lasing in the 1040nm band will be support, which has a lower quantum defect. For example the impact of pumping at 976nm and lasing at 1050nm, versus 915nm and 1100nm, will be to improve the quantum defect from 83% to 93%. The net effect of such pump laser improvements will enable a fiber laser optical-to-optical efficiency in the 80% range.

Finally spectral multiplexing of either the single-mode or the multimode modules will enable reaching even higher output powers without impacting beam quality. For example, spectrally multiplexing multiple multimode modules could permit the construction of a 2-5kW industrial cutting/welding direct diode system that would be extremely reliable and cost-effective. This would be an appealing alternative to current FL-based architectures currently being explored, in which a number of 100-200W single-mode fiber lasers are combined spatially into a multimode output.

The power achievable from a single laser module is limited to the range of several watt. To achieve the power levels demanded by various high-power applications mentioned above, a scaling scheme must be used that can efficiently combine the power from multiple laser sources.

Simple optical combiners do not satisfy the efficiency requirement for fundamental physics reasons. In contrast, wavelength and polarization combiners can be made with zero theoretical optical losses. To implement such combining means, the laser source modules must fulfill certain properties. In addition to producing high output power and efficiency, their emission must be wavelength stabilized to within tight limits and be sufficiently narrow band, as well as possessing a high optical beam quality.

To obtain high output power and efficiency, broad area laser diodes are generally used, however due to their dimensions they tend to oscillate in multiple transverse modes. The broad area output facet of these lasers also presents a challenge for coupling into a single mode optical fiber in applications where maximal brightness is called for.

Wavelength stabilization techniques are well known in the art for single mode (narrow stripe) laser diodes. Distributed feedback gratings as well as distributed Bragg reflectors are commonly integrated into the laser structure, but these exhibit a relatively high wavelength shift with temperature, which can be problematic in high power environments. Other techniques are based on using thermally stable materials in an external cavity, such as Fabry-Perot etalons, free-space diffraction gratings and fiber Bragg gratings.

Similar techniques have been developed also for broad area lasers, however coupling them into an external cavity with the required efficiency is still a major problem. Another stabilization method involves reflecting a spectrally narrow portion of the output emission back into the broad area laser.

One such method has been disclosed by Bardia Pezeshki et al. in US Patent Application 20020085594 in the name of Santur, Inc. The embodiment shown in Fig. 1a has a plurality of DFB laser diodes as used in telecommunications, coupled into an array waveguide grating (AWG) for combining at a common output. A disadvantage of this arrangement is that it requires close tracking of the laser wavelength with the passbands of the WDM device under changing temperature conditions.

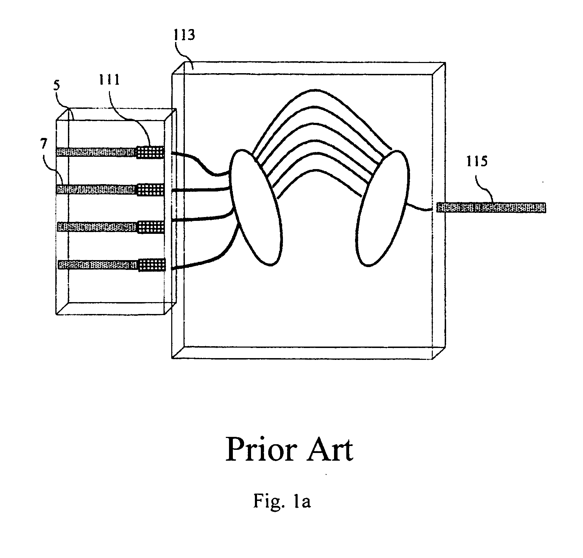

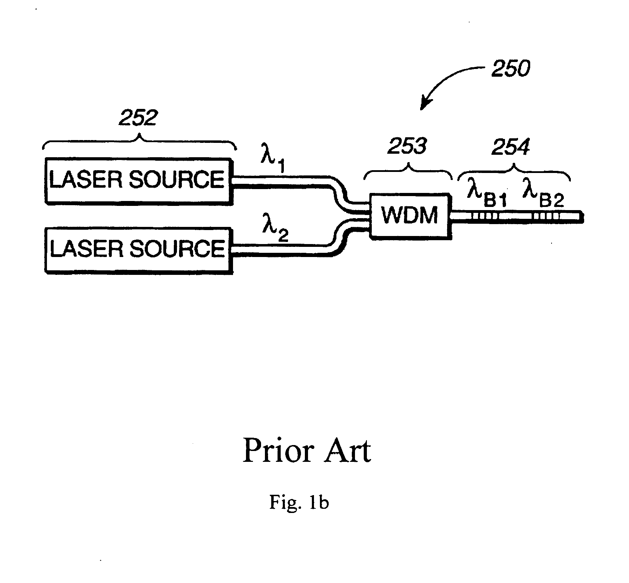

Another method has been disclosed by Robert G. Waarts et al. in US Patent 6,212,310, assigned to SDL, Inc. An embodiment is shown in Fig. 1b where a plurality of optical fiber lasers, each with a different wavelength, is coupled through a WDM device such as a fused taper coupler, dichroic mirrors or grating mirrors into a single output. The output fiber has a Bragg reflector incorporated within it for providing some feedback to the fiber lasers. This has a similar disadvantage to the previous example.

Thus, an object of the present invention is to stabilize the wavelength of broad area multi-mode laser diodes.

Another object of the present invention is to provide an efficient coupling of such laser diodes to a single-mode waveguide or fiber.

A further object of the present invention is to provide a device in which the optical outputs of an array of laser emitters is combined while conserving brightness, and furthermore to combine outputs of multiple arrays of laser emitters into one single-mode or multi-mode output to achieve high optical power levels in the tens to hundreds of watt.

**SUMMARY OF THE INVENTION**

Accordingly, the present invention relates to high power semiconductor lasers based on a laser diode array waveguide grating (DAWG) in which the wavelength is stabilized using an array waveguide grating (AWG) in an external cavity configuration.

Another aspect of the present invention relates to efficiently coupling optical gain element arrays to an AWG.

Another feature of the present invention provides for the efficient and brightness conserving combination of multiple high power DAWG lasers into a single output.

The present invention relates to a high power laser comprising:

a first chip including a multi-mode semiconductor waveguide for providing gain in a predetermined wavelength band, wherein each semiconductor waveguide has a first reflector at one end;

a second chip including an array waveguide grating having an input port coupled to the semiconductor waveguide, and an output port;

a second reflector disposed to receive light from the array waveguide grating output port and to reflect a portion of the light back into the array waveguide grating, thereby defining a laser cavity with the first reflector;

wherein the semiconductor waveguide is dimensioned to support propagation of multiple transverse modes of light having wavelengths in the predetermined wavelength band; and the multiple transverse modes on the first chip are optically coupled to the input port of the array waveguide grating on the second chip.

**BRIEF DESCRIPTION OF THE DRAWINGS**

The invention will be described in greater detail with reference to the accompanying drawings which represent preferred embodiments thereof, wherein:

Figure 1a: Prior art involving an array of semiconductor laser coupled to an array waveguide grating (AWG);

Figure 1b: Prior art showing several lasers sharing a common cavity reflector through a wavelength division multiplexor (WDM);

Figure 2a: Example of a single-mode diode-AWG (DAWG) module design;

Figure 2b: Example of a multi-mode DAWG module design;

Figure 3a, b: Schematic of DAWG wavelength control, stabilization and multiplexing.

Figure 4: Example of non-uniform bar pitch for achieving a prescribed transverse temperature profile in the gain chip;

Figure 5a, b, c: Cross-sectional view of fast axis coupling techniques between gain chip and AWG chip;

Figure 6: Example plan view of slow axis coupling technique between gain chip and AWG chip;

Figure 7a: Basic single-mode laser diode bar (Sbar) - AWG combination using 2-axis lenses;

Figure 7b: Advanced single-mode laser diode bar (Sbar) - AWG combination showing method for eliminating both the fast-axis and slow-axis coupling optics;

Figure 7c: Basic coupling of flared single-mode laser diode bar (Sbar) to planar lens on AWG input, showing various dimensions to be optimized;

Figure 7d: Advanced coupling of overlapping flare single-mode laser diode bar (Sbar) directly to star coupler region on AWG input, showing various dimensions to be optimized;

Figure 7e: Example of multi-mode interference (MMI) Sbar to AWG combination, showing various dimensions to be optimized;

Figure 8: Example of an array of planar lenses for collecting and focusing output of flared diode emitters. Single mode waveguides on the output connect to the AWG. Trim heaters can correct alignment errors between the bar and AWG PLC chip;

Figure 9a, b: Example of technique to avoid high optical intensities at the multiplexed side of the AWG: the slab guide (a) can be cut, and the laterally converging wave allowed to focus in free space (b). A cylindrical lens re-images in the vertical direction;

Figure 10a: L-I-V curves for state-of-the-art JDSU 980nm and 865nm narrow stripe single-mode laser diodes;

Figure 10b: PCE curves for state-of-the-art JDSU 980nm and 865nm narrow stripe single-mode laser diodes;

Figure 11a, b, c: Example cross-section of spatially combined waveguide output into a multi-mode fiber: 1-dimensional array (a), 2-dimensional array (b), and 1-dimensional array into rectangular core (c);

Figure 11d, e: Example cross-section of fiber array ribbon having a different arrangement at each end: at AWG end (d), and output end (e);

Figure 12a: Example of on-chip wavelength multiplexing of DAWG outputs;

Figure 12b: Example of spatially combined single-mode waveguides into multi-mode fiber;

Figure 12c: Example of spatially combined single-mode waveguides into single-mode fiber array on silicon optical bench;

Figure 13a: Overall concept for kilowatt system using passive wavelength combination;

Figure 13b: Schematic of polarization combined DAWG modules;

Figure 13c: Schematic of example 5kW system showing a detailed drawing of the 5 kW system and its components. The example system uses 32 DAWG modules combined via polarization and wavelength multiplexing;

Figure 14: Plot of combined beam propagation factor (BPF) versus near field aperture with ideal optics. BPF maximizes at 0.98 for an aperture 1.5 times the beam waist;

Figure 15: Plot of BPF as a function of aberrations for an aperture of 1.5 times beam waist. There is some optimization of aperture depending on type of aberration;

Figure 16a: 2-dimensional linear plot of modeled WAVMUX near field using an aperture 1.5 times the beam waist;

Figure 16b: 2-dimensional linear plot of Far-field of WAVMUX Beam including aberrations, where BPF = 0.60;

Figure 17: Plot of spectral characteristics of representative polarization beam combiner;

Figure 18: Example chart showing AWG module outputs as a function of relative frequency and polarization. After polarization MUX, the 32 AWG outputs are reduced to 16 beams;

Figure 19a: Example zigzag multiplexing scheme (beam expanding lenses and polarization multiplexers are not shown). Each Level 1 multiplexer employs 3 filters;

Figure 19b: Example of level 2 multiplexer showing outlines of four Level 1 multiplexers. The Level 2 multiplexer employs 3 filters;

Figure 20: Spectral plot of level 1 multiplexing scheme. Filter 1 reflects AWG band 1 (centered at 100 GHz relative frequency), while transmitting AWG band 2 (centered at 200 GHz relative frequency). Filter 2 transmits AWG band 3, while reflecting bands 1 and 2, similarly filter 3 adds AWG band 4 into the beam;

## DETAILED DESCRIPTION

Silica array waveguide gratings (AWG) form the basis of the design for spectrally multiplexing lasers at narrow channel spacing. The diode-AWG (DAWG) concept has inherent advantages over conventional gratings for spectral combining of laser arrays. Firstly, the AWG has extremely high spectral resolution, enabling a large number of laser diode emitters to be packed into a narrow spectral region. Secondly, due to their planar structure, the AWG is well matched for efficient coupling to a diode bar, and it uniquely enables disruptive laser architectures, such as flares, that can greatly increase the optical power per emitter. Thirdly, the concept is cost-effective, scalable, highly manufacturable, and precisely controllable since it is based on silicon wafer processing technology. Finally, it enables a simple, compact, robust, thermally stable DAWG module with fiber-coupled or free space collimated output with minimum amount of micro-optics.

This invention disclosure presents innovative design concepts for the laser diode bar, the laser to silica waveguide coupling, the silica AWG and the silica output coupling to fiber or free space.

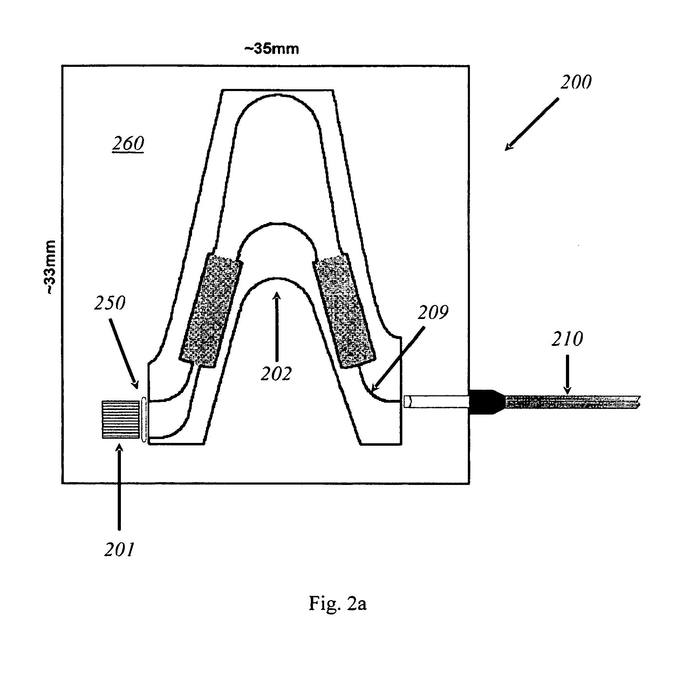

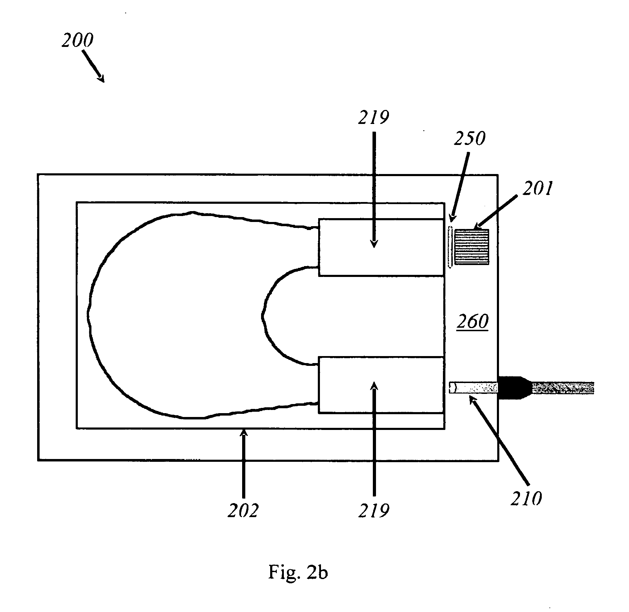

Figure 2a shows an example of a single-mode DAWG module design, while an example of a multi-mode DAWG module design appears in Figure 2b. Referring to these figures, the DAWG module **200** in package **260** comprises a diode bar or semiconductor gain chip **201** optically coupled to an input of an AWG chip **202** through coupling optics **250,** here shown as a separate lens, but may also be integrated on one or both chips **201, 202.** In the case of the multi-mode DAWG module, input and output may be achieved through a slab waveguide regions **219,** with the output coupled directly into an output fiber **210.** For the single-mode counterpart, the input may have individual waveguides on the input adjacent to the coupling optics **250** and a single waveguide **209** for coupling to an output fiber **210.**

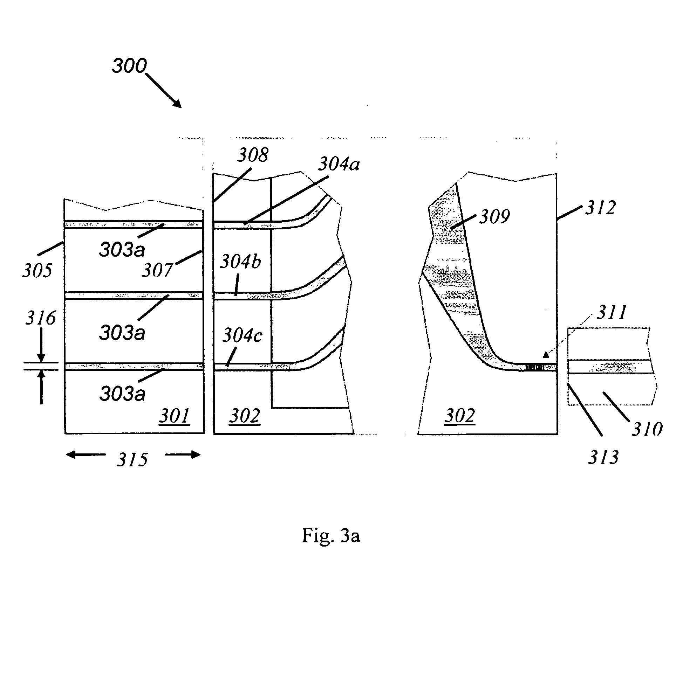

The function of a DAWG is related to spectral combining concepts that have been demonstrated in recent years using conventional gratings but with some distinct advantages. As seen in exemplary design in Figure 3a, each individual laser diode **303a-c** is an external cavity laser where the feedback comes from a broad spectrum grating (or simple reflector) **311** placed at the far end of a silica AWG **302.** Required coupling optical elements are not shown for simplicity.

The exact lasing wavelength of each emitter is determined by the AWG **302,** which functions as an extremely high-order diffraction grating. Scaling this approach to a diode bar (also referred to as "SBar" for short) **301** matched to the AWG **302** with many channels **304a-c** (three shown in this example) creates substantial advantages. Typically, 40 channels are not uncommon for DWDM systems. The AWG **302** not only controls the wavelength and wavelength spacing of the individual laser diodes **303a-c,** but also multiplexes them into a single waveguide output **309.**

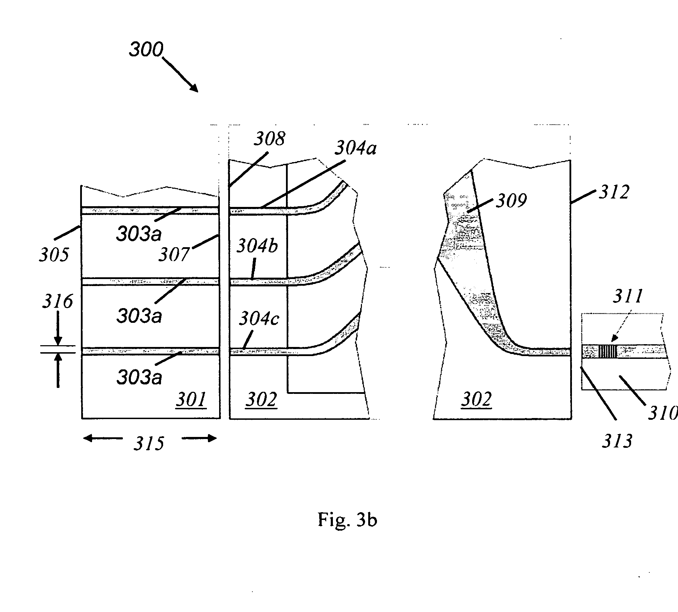

Still referring to Figs. 3a and 3b, optical feedback for the external cavity DAWG laser **300** can be provided in the output waveguide **309** or in the output fiber **310** coupled to the output photonic light circuit (PLC) facet **312.** One option is to use a weak Bragg grating **311** to provide a few percent of feedback to sustain oscillation. The grating **311** can either be in the output waveguide **309** using a shallow etch on the core of the guide or in the output fiber **310** using UV writing technology. The weak grating should have sufficient bandwidth to capture the range of the AWG spectrum. Another option is to utilize the Fresnel reflection, R~4%, at the output PLC facet **312** of the AWG chip **302** or at the input facet of an output fiber. A final option is to position the fiber facet **313** within a few microns of the output PLC facet **312,** thus generating effectively one surface with a reflectivity that is determined by the gap between the facets according to the Fabry-Perot formula. The gap can be set at the time of manufacture in order to create an effective reflectivity in the between 0% and 16%. With this addressable range, it should be possible to adjust the feedback to optimize the performance of the laser.

Alternative techniques for feedback may implement a single-mode Bragg grating with a narrow reflection band. Such a grating can be written into a photosensitive core of a double-clad multi-mode fiber or fabricated by etching into a core of a multi-mode waveguide on an optical chip, such as a silicon or silica photonic light circuit (PLC). Although such a reflector is suitable when the double-clad multi-mode fiber or PLC is coupled directly to a multi-mode semiconductor waveguide e.g. **303a,** it would be of limited advantage to use it as a reflector **311** on the output waveguide of the AWG chip **302** illustrated in Figs. 3a and 3b. The reason is that while the AWG chip **302** can provide efficient coupling with a multi-mode semiconductor waveguide e.g. **303a,** it also restricts the spectral bandwidth of the respective outputs to different narrowband wavelength bands, which are not necessarily compatible with the narrow reflection band of a single-mode Bragg grating.

There are multiple possibilities for output coupling from the AWG chip **302,** including a fiber output as well as free space output. The fiber output concept (single-mode, multi-mode, polarization maintaining, etc.) can be accomplished by focusing the AWG waveguide output onto the fiber, butt coupling the fiber to the waveguide facet (possibly in physical contact, e.g. using a convex polished fiber tip against the waveguide facet), or even bonding or fusion splicing the fiber into the silica AWG. Another concept is directing the output through a collimating lens (as part of the AWG chip **302** or a discrete optical element) and using the collimated power. The free space option is especially useful for further beam combining.

The SBar design discussed here is based on conventional laser diode structures as shown in Figures 3a and 3b. For example, rectangular shaped gain regions of laser diodes **303a-c** have a particular length **315** (i.e. 1mm or higher), particular width **316** (i.e. ~4 $\mu$m for single spatial mode or >10 $\mu$m for multi-mode operation) and front **307** (typical R < 30%) and rear **305** (typically R > 90%) facet reflectivity.

Special considerations for laser diode design for AWG coupling fall in a few distinct areas:

· Front facet coating
· Layout of laser diodes in a bar or short bar (SBar) format)
· Optimizing design for maximum diode to AWG coupling
· Optimizing active region design for efficient wavelength locking to the AWG

Optimizing the laser diode active region for higher gain includes using a wider gain bandwidth gain material to accommodate a wider tuning range of the AWG.

The front facet coating **307** should be modified to be as low as possible (i.e. <1%) to minimize feedback from retro-reflections into the cavity and optical interference between the front facet **307** and any other discontinuities in the AWG **302.**

The front facet **307** of laser diodes **303a-c** or input facet **308** of the AWG **302** (for example in Fig. 3a), or both, can also be angled to reduce unintended optical feedback, as is well known in the art.

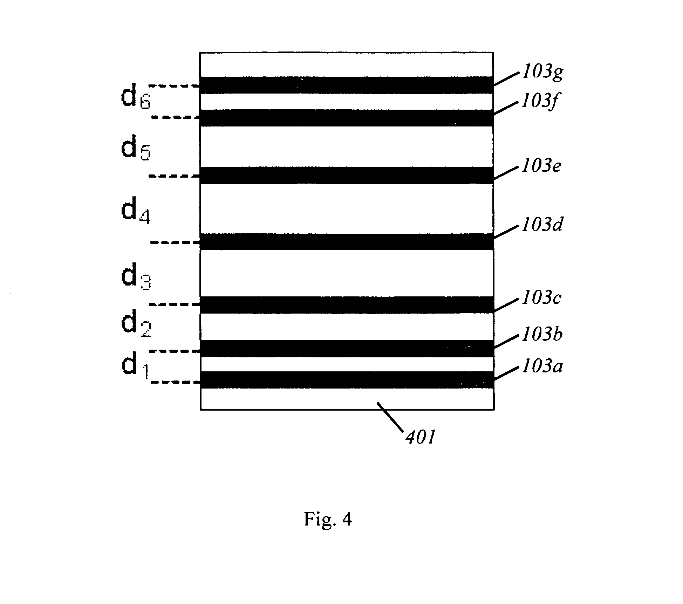

The layout of the laser diodes **303a-c** in bar **301** is important to DAWG **300** performance. A typical laser diode bar **301** is 1cm long with evenly spaced laser diode emitters **303a-c.** It is advantageous to reduce bar length **315** in order to reduce smile, and especially, the misalignment between the laser diode bar **301** and the AWG **302**. In addition, for the DAWG module the spacing between the laser diodes **303a-c** will be determined by the requirements of the AWG design. For example, a single-mode DAWG pitch might be around 30 $\mu$m in order for the AWG **302** to be a small as possible. Another possible modification could be a non-uniform pitch as shown in Figure 4 by varying distances $d_1$ through $d_6$ between laser diodes **103a** through **103g** respectively. The non-uniform pitch could compensate for non-uniform heating and active region temperature, or be adjusted to achieve some prescribed temperature profile.

High coupling efficiency between the laser diode bar **301** and the silica AWG **302** is important to enable high power output and reliable operation of the laser. Minimizing excess optical components is important for reduced parts cost, in addition to enabling easier alignment or even self-alignment, which is important for high manufacturing yield and low production cost.

Optimizing a design for optical coupling includes adjusting beam divergence in the fast-axis and slow-axis to match the input requirements of the AWG. Typical fast-axis divergence can be 20 degrees or more. Special wide waveguide or optical cavity designs can reduce this to less than 10 degrees. Reduction in laser efficiency may be compensated by an increase in laser diode to AWG coupling efficiency.

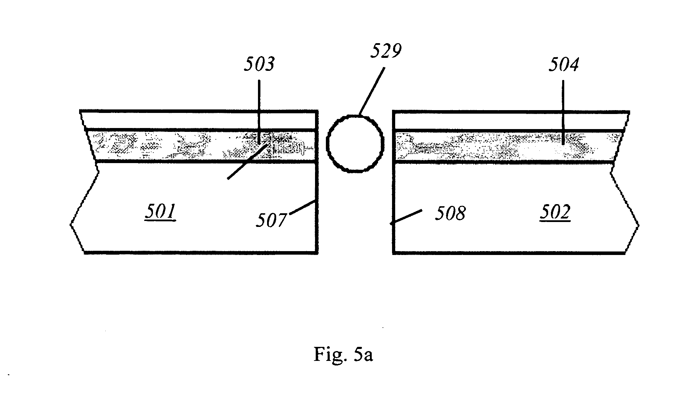

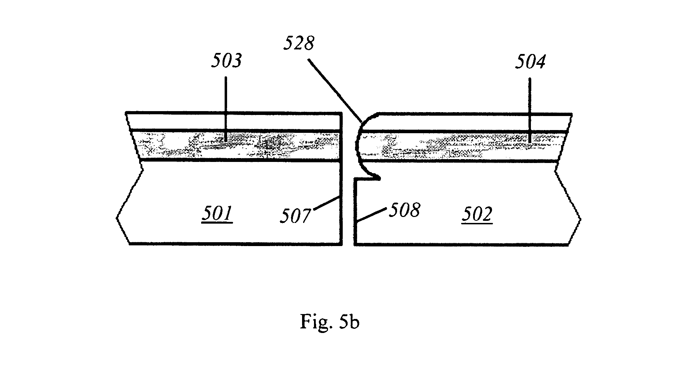

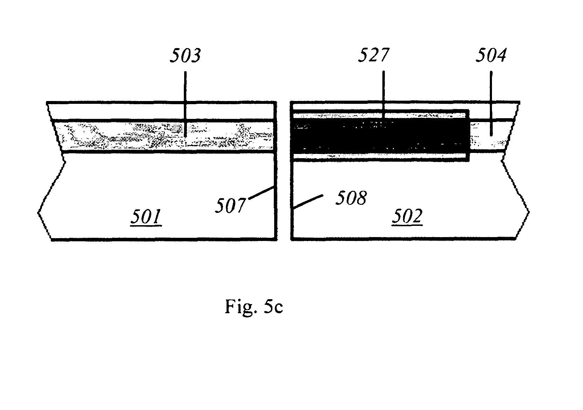

The first coupling efficiency issue to be considered, typically the technologically more demanding one, is the fast-axis, or perpendicular, optical beam divergence at the front facet **507** of the laser diode bar **501** and at the rear facet **508** of the silica AWG **502** as illustrated in Fig. 5a. The light typically diverges about 15 to 30 degrees upon exit from front facet **507** into free space. The simplest approach is to use a lens **529** to couple the light beam, for which a simple rod lens may be sufficient. More advanced solutions are etching the lens **528** into the silica waveguide **504** as shown in Figure 5b, or making a graded index (GRIN) lens **527** as shown in Figure 5c, or a vertical taper by varying the effective indices of the silica layers.

Another option to further improve the coupling efficiency is to bond the laser diode bar **501** directly to the silica AWG **502**. A final option is to implement a mode expander section near the output facet **507** of the diode bar **501**. Such a mode expander could be realized by, for example, re-growing a suitable structure onto the bar or by etching away parts of the high-index layers in order to reduce the effective index and allow waveguide modes to expand.

The combination of an integrated fast-axis coupling optic (any of the above options except for a discrete lens such as the rod lens) with a simple butt coupling in the slow axis, with a gap of only a few microns or tens of microns, has the added benefit that the lateral mode structure in the laser bar is not significantly disturbed during the coupling across into the silica waveguide. Linking the modes from the laser bar directly into the silica waveguide is a novel concept that is enabled by the above-disclosed coupling schemes and opens the possibility of new optical structures leveraging waveguide modal effects that have not been previously exploited. Examples of such structures will be discussed in subsequent disclosures.

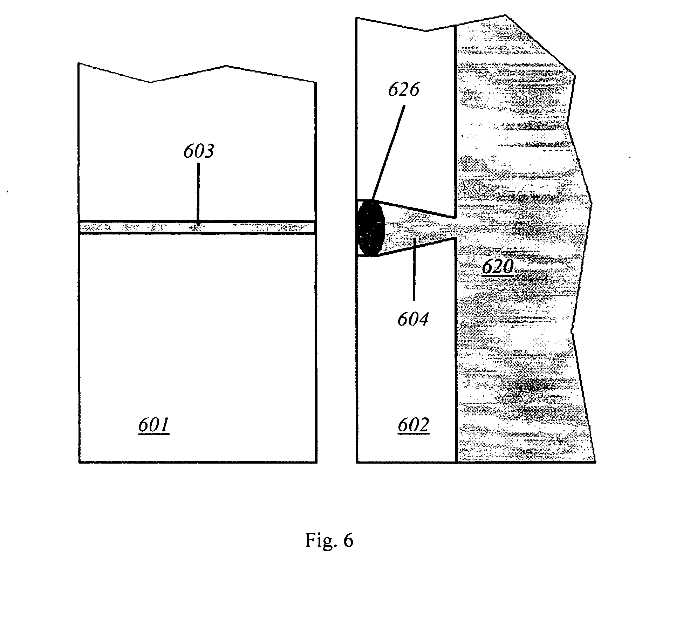

Another coupling efficiency issue to be considered is the slow-axis, or parallel, optical beam divergence at the front facet **607** of the laser diode bar **601** and at the rear facet **608** of the silica AWG **602** as illustrated in Fig. 6. The light typically diverges about 5 to 8 degrees upon exit from front facet **607** into free space. An advanced solution is to integrate a planar lens **626** into the waveguide **604** on the silica AWG **602**. The so-called planar lens **626** can be realized by either a classical convex lens shape or by another AWG operating in zero order.

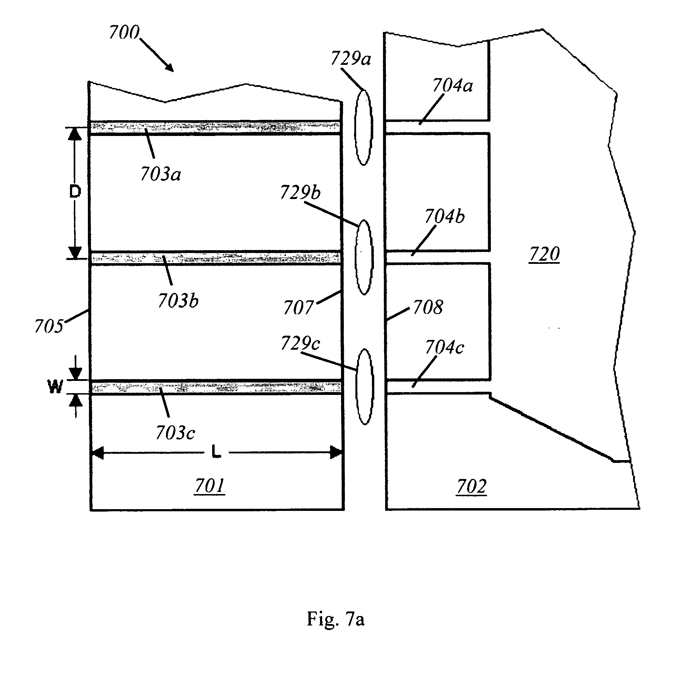

Fig. 7a shows a conventional approach using lenses **729a-c** to couple the light beam from the front facet **707** of the laser diode bar **701** and at the rear facet **708** of the silica AWG **702**, but each laser emitter **703a-c** and waveguide **704a-c** pair, respectively, will need a separate lens. However a lens array has cost and optical alignment implications.

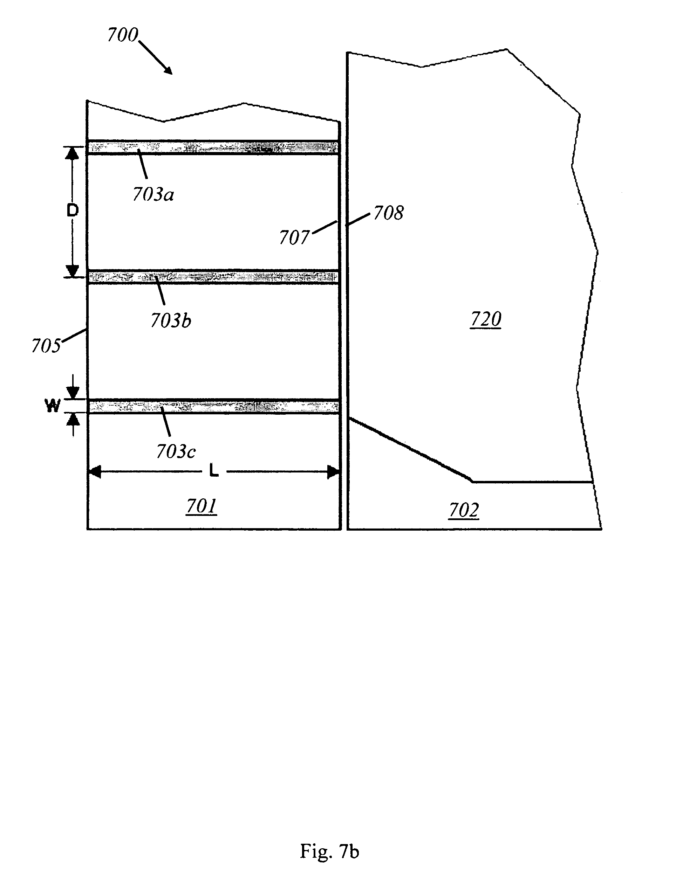

Yet another approach to efficient coupling is presented in Fig. 7b. The laser diode bar **701** is directly coupled into a freely diverging region **720** of AWG **702**. A simple option is to position the laser diode bar **701** close enough to the AWG **702** so that there is an effective lateral butt coupling and no focusing is needed. It should be possible to accommodate a gap on the order of 10 micron between front facet **707** of the laser diode bar **701** and at the rear facet **708** of the silica AWG **702**, but this rules out the use of any discrete optics (e.g. rod lens) for fast-axis coupling, as was discussed above.

When the laser emitter waveguides **703a-c** are directly coupled into a star coupler **720**, the waveguides should be slightly converging as they enter the coupler. It would be desirable to bend the laser emitter waveguides **703a-c** slightly so that they effectively converge at the front facet **707** where the light beam crosses the gap as it enters the star coupler **720** through rear facet **708** of the silica AWG **702**.

Another coupling efficiency issue to be addressed is bending mismatch between the laser diode bar **701** and silica AWG **702**, so-called smile. One concept to alleviate this problem is to use a shorter laser diode bar **701**, i.e. limiting the length to a few millimeter, whereby the total and percentage of bending can be maintained at less than a few micron. For smile of constant curvature, the total smile scales as the square of the bar width, so a 5mm bar will have only one-quarter the smile of a 1cm bar. Another concept is to actively bend the silica using bimetallic strips to match the laser bar smile during alignment.

AWGs set the level of spectral filtering, which determines, ultimately, how many single emitters can fit into a particular assigned bandwidth. With their long, lithographically precise optical delay lines, AWGs can achieve GHz range channel spacing over a small free spectral range (FSR), and pack many emitter wavelengths into a small bandwidth. However, since efficiency is a central goal, the optical coupling losses from the laser bar and through the AWG must be made as small as possible. This becomes the main factor in design trade-offs for the AWG. Table 1 shows an estimated loss budget for a hybrid DAWG structure. Because laser diode to AWG coupling ("LD to PLC") is a fundamental challenge, it is assigned the largest share of the loss budget.

Table 1: DAWG Loss Budget

| Loss Element | dB Loss | Trans. | Comments |
|---|---|---|---|
| LD to PLC | 0.7 | 85% | |
| Planar Lens | 0.2 | 95% | |
| AWG design loss | 0.2 | 95% | |
| Propagation Loss | 0.3 | 93% | 15cm Long at 0.02dB/cm |
| PLC to fiber | 0.2 | 95% | |
| **Total Efficiency** | | **70%** | |

AWG design losses are mainly concerned with the amount of the freely expanding wave-front in the star coupler that is to be coupled into the single mode waveguides of the AWG. The choice of number of the array guides immediately determines the amount of clipping of the expanding wave, and thus power loss. A sufficient number of guides is generally used to keep the loss level well below 0.1 dB, though this does impact overall size of the AWG. JDSU has developed a number of proprietary methods for grading the transition between the slab and the single mode array waveguides which result in losses of about 0.1 dB per star coupler. The amount of light lost to cladding radiation modes can be reduced by making the transition adiabatic. These techniques are standard in certain commercial AWG production lines, and have a direct benefit on achieving low loss.

A major challenge for low optical loss is the physical size of the AWG at the narrow channel spacing required. Narrow band frequencies imply long path length delays, and all of the AWG designs considered for the high power applications disclosed here are much larger than commercial telecom devices. Waveguide propagation loss, which plays a minor role in telecom devices, is very important here. A commercial standard 0.8% index delta waveguides have propagation losses of 0.03 dB/cm. This loss is not due to absorption, but rather due to scattering off the etched sidewalls of channel waveguides. Optimizing the waveguide size to minimize modal overlap with the sidewalls, while retaining enough confinement to provide require bend radii is one way to reduce such optical loss.

The total optical path length through the AWG is the biggest determining factor in the amount of propagation loss a design will have. The size of different AWG designs can be compared using a formula that determines R, the length (radius) of the star coupler regions.

$$R = \frac{n_s d_i d_a \Delta\lambda}{n_s \lambda_0 FSR}$$

Here, $d_i$ is the pitch of the input and output waveguides at the star coupler, $d_a$ is the pitch of the array guides, $\Delta\lambda$ is the channel spacing, $\lambda_o$ is the center wavelength, FSR is the free spectral range and $n_s$ is the planar waveguide effective index. It is important to note that a larger star coupler, for a given input waveguide numerical aperture, will require more array waveguides to catch the radiating wave, so this may have the most impact on the AWG total path length.

An important trade-off is the pitch of the inputs to the AWG. As discussed previously, the laser array can be coupled to a set of individual single mode waveguides which are then directed to the AWG on the PLC chip. Since the waveguide mode size is on the order of 6 micron or less, the pitch and star coupler radius can be small. Going to higher index delta can further reduce the pitch.

One other consideration that may be of relevance is the choice of the AWG substrate. For certain manufacturers, conventional AWGs are fabricated on a silicon substrate. For a DAWG device disclosed in accordance with the present invention, another potential option would be to use a silica substrate. An all-glass device thus generated may have some advantages from the standpoint of fabrication and packaging processes, for example, the possibility to etch a fast-axis lens into the AWG facet as mentioned above. It could also be more transparent than a silicon substrate, depending on the laser wavelength, so it may not absorb as much of the scattered light from the AWG. On the other hand, it will have a lower thermal conductivity so the light that does get absorbed may cause more localized heating.

According to the invention disclosed herein, laser diode emitters will each generate a single spatial mode output that can be coupled into a single spatial mode at an AWG output. Single spatial mode is important for a variety of applications requiring high brightness, small spot sizes or large depths-of-field. Multi-mode DAWG designs will also be presented.

Conventional narrow stripe single spatial mode laser diodes can be integrated into the DAWG concept. However to enable even higher single mode efficiency and power there are some new designs that can take advantage of the AWG properties.

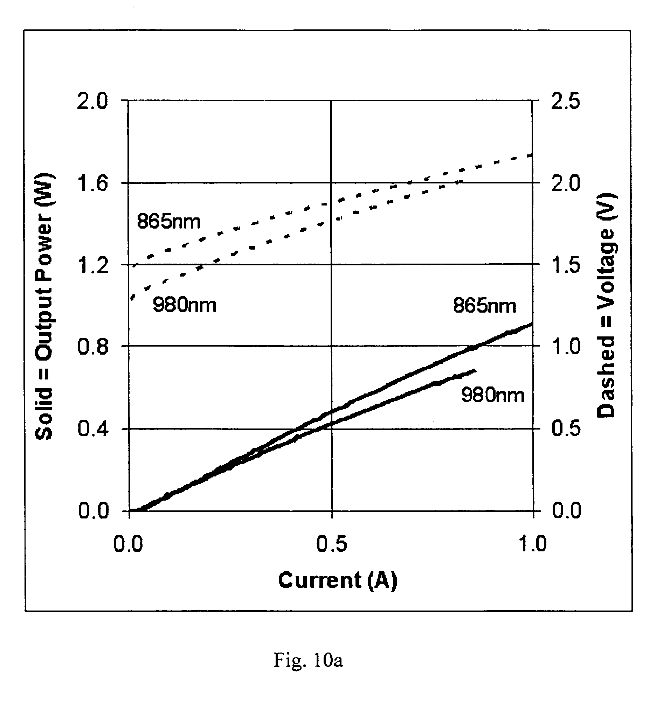

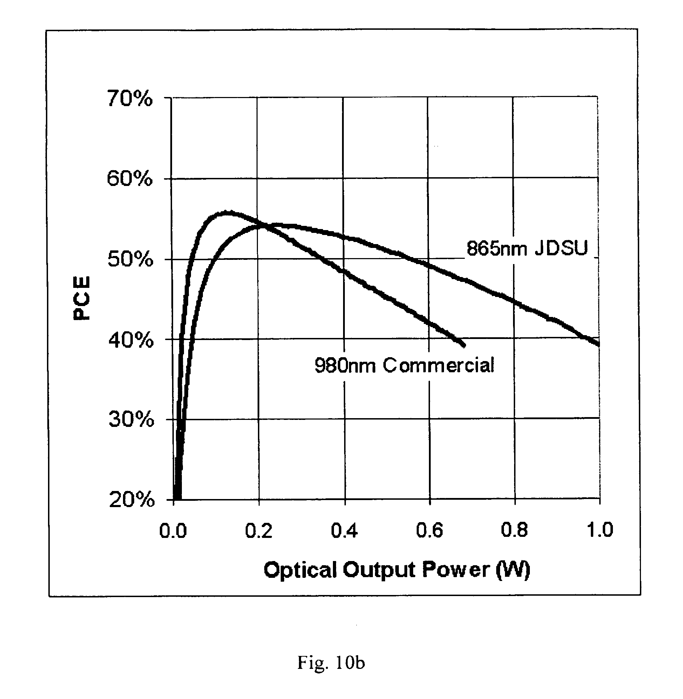

Exemplary state-of-the-art narrow-stripe single-mode laser diode output characteristics are shown in Fig. 10a, while the corresponding terminal voltage characteristics appear in Fig. 10b. The commercially available 980nm JDSU Model 6560 laser diode is rated for 0.65W operation and the power conversion efficiency (PCE) peaks at about 55%. JDSU has also made high power 865nm single-mode diodes, an example laser diode being operated at more than 1W optical output power. The reduction in wavelength from 980nm to 865nm corresponds to a higher terminal voltage due to an increased energy band-gap in the semiconductor gain region, while slope efficiency (higher photon energy) is also higher, so the net shift in PCE going from 980nm to 865nm is small.

Two example designs for a narrow-stripe laser DAWG are shown in Fig. 7a and 7b. The latter makes use of integrated coupling optics at the rear facet **708** of the silica AWG **702,** a cross-section of which is illustrated in Fig. 5b, in particular by reference numeral **528.** Both the fast-axis and slow-axis external coupling optics are thereby obviated. For either case the laser diode design will need to be optimized for best power coupling, for example, by adjusting beam divergence. Also the laser must be designed for best feedback stability using methods such as adjustment of coating reflectivity values or by modifying the active region structure and composition.

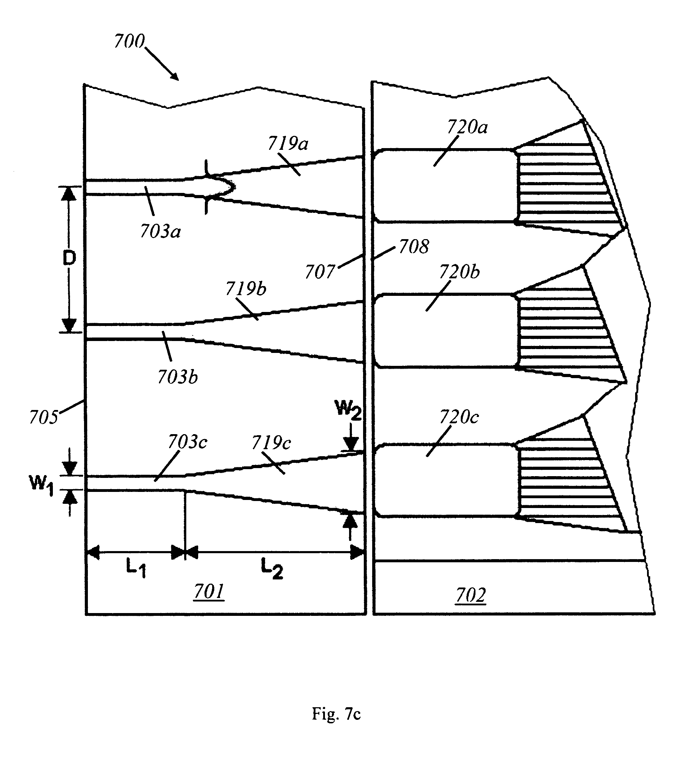

To reach higher single mode powers that exceed the facet catastrophic optical degradation (COD) power density limit, the output aperture of the device has to be increased while diffraction-limited single spatial mode lasing is preserved. One potential design incorporates waveguides **703a-c** that have corresponding flared sections **719a-c** (Figure 7c). Flares **719a-c** have been demonstrated at different wavelengths by many groups. JDSU has achieved 2.2W continuous-wave diffraction limited monolithically integrated master oscillator power amplifier (MOPA) at 854nm. JDSU also reported 5.25 W power from a flared amplifier at 860nm and has significant Intellectual Property on various flare designs. The theory behind a flare design is that the single-mode generated in the back part of the laser diode experiences amplification in the flared section **719a-c.** The flared design has rarely outperformed traditional laser diode designs for a variety of reasons, such as low PCE due to non-uniform mode and current injection as well as astigmatism, but these can be addressed in a DAWG combined design. As mentioned previously, in the flared oscillator architecture, planar lenses **720a-c** would be implemented at the AWG input to refocus the diverging output from the flare **719a-c** and accommodate the laser pitch **D** as shown in Figure 7c. Various dimensions to be optimized are designated by D, $W_1$, $L_1$ and $L_2$ (giving a total length **715).**

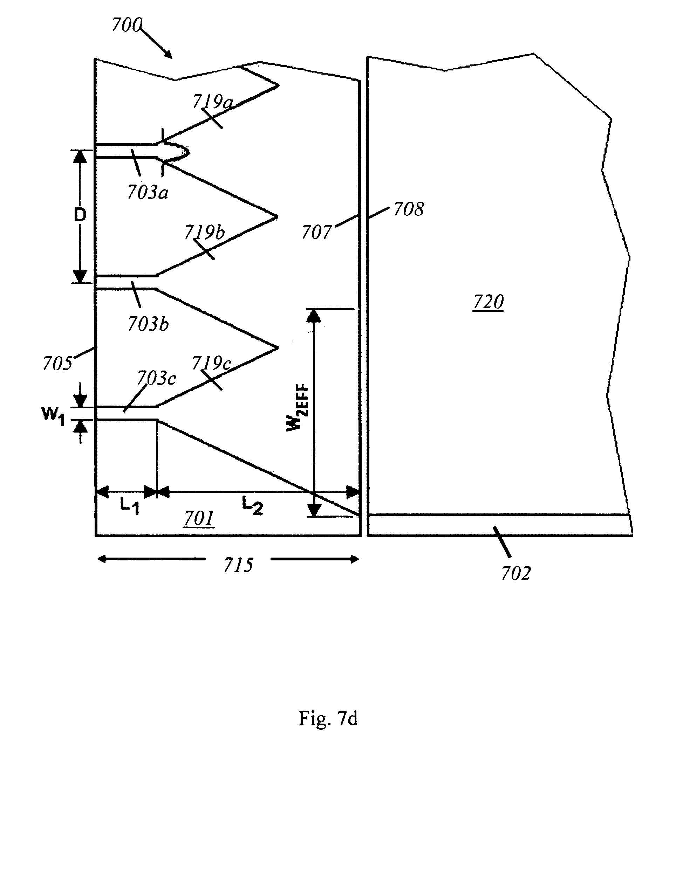

The overlapping flare (OLF) illustrated in Fig. 7d is a novel architecture, being essentially a variation on the flared oscillator approach in which an array of tapered oscillators **703a-c** merges directly into a first star coupler **720** in the AWG **702.** While the laser diode waveguides **703a-c** are not modified appreciably, the corresponding flared sections **719a-c** have been spread to such a degree where their effective width $W_{2eff}$ is larger than the laser diode waveguide pitch **D,** the overlap being such that the pumped region is continuous along the front facet **707** of the laser diode bar **701.** The advantages are low optical complexity and higher throughput, as well as higher laser efficiency and reduced susceptibility to facet damage due to a larger, more uniformly filled active region.

As indicated in Figure 7d, there is a wide range of parameters D, $W_1$, $L_1$, $L_2$ and $W_{2eff}$ over which the OLF can be optimized. Although the star coupler imposes certain restrictions on the laser pitch, the geometry can be optimized to provide a large active region and output aperture on the diode bar. One of the known problems of flared lasers is beam filamentation that makes field distribution non-uniform and limits diffraction-limited power. JDSU has developed approaches to prevent filamentation by patterned current pumping. In both flared approaches, various electrical pumping schemes and multiple contacts can be used in order to optimize efficiency and beam quality.

Another novel architecture, which enables single-mode output from a conventional broad-area laser through the phenomenon of multimode interference (MMI) in step-index waveguides. Broad-area lasers have not only much higher power but also higher inherent efficiency than traditional single-mode lasers and tapered oscillators since the lasing volume is more uniformly filled. Furthermore, this approach leverages JDSU's existing investment and demonstrated expertise in broad-area laser technology, with demonstrated 14W optical power output per device at over 70% electrical-to-optical conversion efficiency.

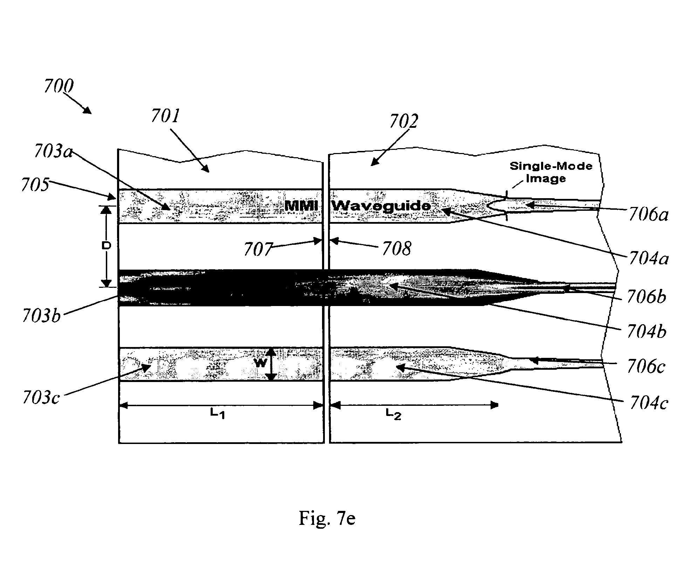

Figure 7e shows the physical layout of laser **700** with multiple MMI cavity lasers feeding into the input star coupler of an AWG. A compound MMI region is formed by the length $L_1$ of laser diode waveguides **703a-c** on laser diode bar **701** plus a certain length $L_2$ of silica waveguides **704a-c** on the AWG chip **702** such that the region is self-imaging in double pass. The self-imaging length for a symmetrically fed MMI with multiple regions of different refractive indices is given by the following formula:

$$\Sigma_i \, L_i/n_i = mW^2/ \, \lambda_0$$

where $n_i$ is the effective index of refraction, W the waveguide width, $\lambda_0$ the free-space wavelength, and m an integer. For a double-passed, symmetrically-fed 100 mm wide waveguide and a 3 mm long laser chip, the multimode silica waveguide region will be an integer multiple of 7.4 mm long in order to provide self-imaging.

The operation of the MMI cavity laser may be understood as follows: the AWG **702** provides monochromatic, single-spatial-mode feedback into each of laser diode waveguides **703a-c** via single-mode waveguides **706a-c** from the star coupler (not shown). Many lateral modes of the compound MMI region are excited, so that the input field rapidly spreads to fill the MMI laterally. The field crosses from the silica waveguides **704a-c** on the AWG chip **702** into the laser diode waveguides **703a-c** on laser diode bar **701,** undergoes amplification, is reflected at the HR-coated rear laser facet **705** and returns through the laser diode waveguides **703a-c** back into the silica waveguides **704a-c.** Following one round trip through the MMI, the field reaches its self-imaging length and re-forms into the single spatial mode at the point where the silica waveguides **704a-c** meet the single-mode waveguides **706a-c,** respectively.

As in the other architectures, the AWG converges lasers of different wavelengths into a single single-mode output and provides appropriate optical feedback to each of the laser diode waveguides **703a-c.** In this way, while there is a relatively small single-mode spot in the silica waveguide at the start and end of the round trip through the MMI, the optical field gets spread out laterally during the time that it is traversing the front laser facet **707** to rear facet **708** and propagating inside the laser diode waveguides **703a-c.** This enables the full inherent efficiency and optical-power capability of the broad-area laser to be leveraged.

In a further novel architecture, fundamentally different from the preceding one, the multimode output end of the compound MMI region terminates directly into the star coupler of the AWG without any intervening section comprising the single-mode waveguides **706a-c.** As a result, there is the equivalent of many single-mode beams being coupled into each compound MMI region, each at a slightly different color and lateral position at the face of the MMI, as determined by the AWG. The imaging properties of the MMI must be fixed so that each effective single-mode spot images back onto itself following a round trip through the laser. This is a lower-symmetry situation than in the preceding architecture, so the criterion becomes:

$$\Sigma_i \, L_i/n_i = 8mW_2/\lambda_0.$$

where all symbols retain the same meaning as before.

In one embodiment, a diode bar contains an array of multimode emitters which are coupled directly across into the star coupler of an AWG. Sample dimensions satisfying the criterion would be a 3mm long laser diode (used in double pass) and an emitter width of 16 micron. Since a single-mode spot is typically 4 micron wide, there would be the equivalent of about four resolvable wavelengths across the width of the face of the MMI. Radiation of each wavelength rapidly spreads across the MMI waveguide and intermingles with the other colors as it propagates the length of the diode and reflects back at the end facet. Upon re-arrival at the facet, the individual wavelengths reach their imaging length and thus resolve themselves back into their localized region with their specific wavelength. The AWG now merges all of the wavelengths from this MMI, along with all of the wavelengths from all of the other MMIs, into one single-mode output beam.

There are several degrees of alignment tolerance to be considered: vertical (aligning the planes of the laser bar and silica AWG or PLC), horizontal (aligning the laser diode waveguides along the SBar to corresponding AWG waveguide inputs), and rotational, including deviation from perfect flatness (smile).

The vertical dimension is the most critical for mode-matching and alignment, as the laser mode is typically on the order of a micron, and the optical beam divergence is correspondingly high. Typically this dimension causes the greatest loss when coupling from single-mode laser diodes. One of the most successful technologies for high-efficiency coupling of high-power pump lasers into single mode fiber is the tapered fiber lens. These tapers terminate in an 8 $\mu$m to 9 $\mu$m radius of curvature which acts as a small microlens to couple the dimensions of the laser (typically 1 x 3 $\mu$m) efficiently into the ~10 $\mu$m single-mode fiber (SMF). One method for forming microlenses is to laser machine the ends of the fiber using a $CO_2$ laser.

In a similar manner, the facet of a PLC chip can be polished to a sharp point and then the glass can be reflowed

with a $CO_2$ laser. It is preferable to use a silica instead of silicon for the substrate in order to avoid coefficient of thermal expansion (CTE) mismatch in this process. The result is a cylindrical facet microlens whose radius of curvature can be controlled by the polish angle and the laser intensity. Both the laser facet and the silica waveguide facet should be ultra-antireflection coated, and the spacing between them should be a few microns. JDSU has extensive expertise with tapered fiber lenses, achieving coupling efficiencies as high as 85% in 980nm pump laser manufacturing. Since only one dimension need be controlled on the PLC, even higher coupling efficiency can be expected.

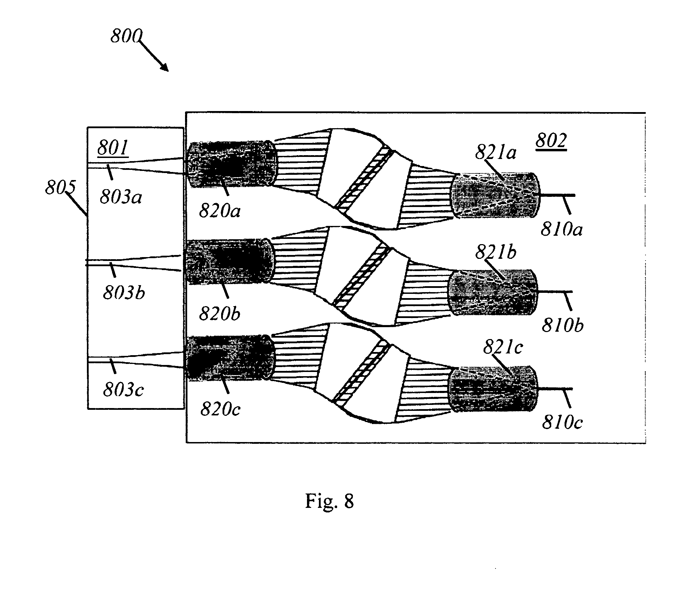

The horizontal alignment problem is much less severe because the dimensions of the diode structures (flares and MMIs) are on the order of hundreds of micron. More complete descriptions of these approaches are given in later sections, but a short discussion of the horizontal alignment considerations are given here. In the flared-oscillator diode architecture, novel planar waveguide lenses can incorporated to refocus the diverging output from the flares into single-mode waveguides that transmit the power into the input star coupler of the AWG, as shown in Figure 8. These waveguide lens structures **820a-c** work on the same principle as an AWG, but without the wavelength dispersion. An input spot enters a star coupler and spreads out to illuminate a waveguide array. The array guides redirect the light to form a converging wave-front in output star couplers **821a-c** which re-image the input into output single-mode waveguides **810a-c** respectively. Changing the radii of curvature in the output star coupler enables different magnifications to be realized. Trim heaters can be used to provide a phase tilt which can move the spot along the output focal arc, so that the device can be adjusted to compensate for alignment errors occurring during bonding the laser diode chip **801** and AWG PLC chip **802.**

In the overlapping flare architecture, the beam propagates directly from the diode structure into the input star coupler of the AWG. No precise lateral alignment is needed, as the lateral position of the diode bar with respect to the AWG will have only a slight impact upon the output wavelength. Displacements of up to several micron will generally cause much less than 1 GHz wavelength shift.

In the MMI architecture, a multimode waveguide on the diode chip needs to be coupled into an equally sized waveguide on the silica chip. Given the width of the waveguides (on the order of 100 $\mu$m) and the very small gap of only a couple of microns between the waveguides due to the use of the facet microlens to couple in the vertical axis, a horizontal positioning accuracy on the order of one micron will be adequate to give very high lateral coupling efficiency.

To address smile and rotation, it is preferable to use as short a bar as possible (2-4 mm) to minimize the total range of smile. This short bar length can be implemented due to the very high PCE of the JDSU diodes with the consequent reduction in thermal load as compared to conventional bars. If necessary, the PLC may also be flexed slightly using bimetallic strips to match the laser bar smile. This is another significant benefit of the DAWG architecture compared to conventional micro-optic coupled architectures.

One concern is that the highest intensities will occur in the multiplexed output guide of the AWG. This must be a single mode structure to enforce wavelength combining of the laser sources. The small core size of single mode waveguides (and fibers) warrants a discussion of their power handling capabilities.

The bulk silica optical damage threshold quoted in the literature is about 20 $W/\mu m^2$. Typical waveguide mode sizes (fitted Gaussian waist, $1/e^2$ in intensity) for 0.8% and 1.5% index delta are 4.9 mm and 3.2 mm respectively, which implies that the guides will be able to handle optical power on the order of 200W. Even higher power densities have been demonstrated in silica fiber using kilowatt CW fiber laser output. The analogy between silica guides and fiber is accurate since they are both fabricated using chemical vapor deposition (CVD) from the same ultra-pure gas sources, and use the same doping materials (boron, phosphorus, and germanium).

Depending on the feedback and output coupling scheme chosen, there may also be a need for anti-reflection coatings on waveguide or fiber facets. Such coatings typically have lower damage thresholds than the bulk material and may prove to be a limiting factor.

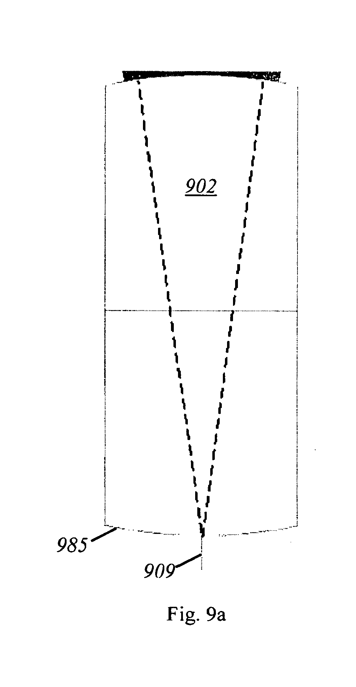

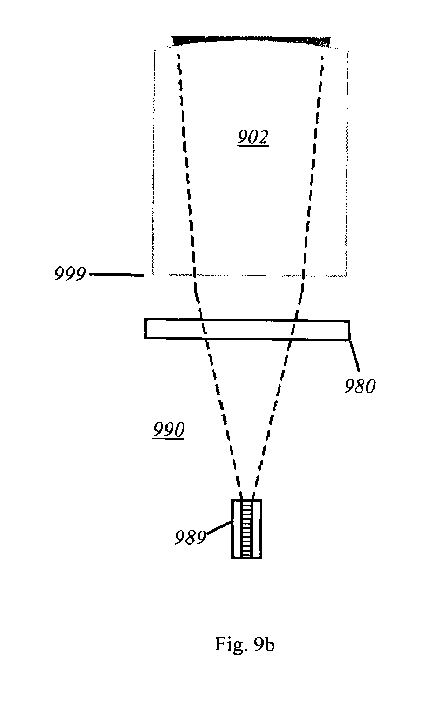

In the event that the damage limits are found to be much lower than required, there is a straightforward mitigation technique. Figure 9a shows a typical planar waveguide **902** at the output of an AWG star coupler in which an output beam is focussed to a point **909** on a curved focal plane **985.** Since the optical wave is simply freely propagating in the planar waveguide or slab **902**, the slab **902** can be cut short along a line **999** in Fig. 9b, and the wave allowed to continue focusing in free space to a high-power-handling, large-core optical fiber **989**. A cylindrical lens **980** can be used to collect and refocus the light in a vertical direction. Cutting the slab only a few hundred microns from the focus will reduce the intensities substantially and allow the use of short focal length cylindrical microlenses, simplifying packaging and improving reliability.

Since the AWG controls the wavelength and does not require single-mode operation, a version using multimode emitters is also possible and covered in this DI. The output of the AWG, and the output fiber coupled to it, would typically match the emitter size, unless magnification or demagnification were implemented in the AWG. For applications not requiring the highest possible beam quality, a multimode approach may provide advantages over single-mode including higher laser bar efficiency, higher coupling efficiency, and simpler designs and smaller chips because of the ability to use fewer emitters, each operating at higher powers than in the single-mode case.

The AWG could be used to tailor the output beam quality of the multimode emitters. For example, it could be designed to transmit and reflect back radiation within a relatively narrow lateral numerical aperture (NA), compared to the normal NA of about 0.15 for a multimode emitter. Alternatively, it could even be designed to cause the emitter to lase preferentially in specific high-order modes in order to optimize the extraction efficiency, for example. Either of these options could be realized by tailoring the transmission profile as a function of NA, basically by giving the various waveguides in the array of the AWG varying transmission values. The waveguide array could even be tailored to rearrange the angular power density distribution.

Since the output of these devices will be multimode laterally in any case, it is conceivable also to relax the single-mode constraint in the vertical dimension on the AWG, without adversely affecting the usefulness of the device. Having two vertical modes rather than one in the AWG waveguide, for example, could potentially greatly simplify the challenge of the single-mode to single-mode coupling in the vertical axis between the bar and the AWG, and increase the efficiency. However, this will cause modal dispersion in the AWG corresponding to probably several nanometers' shift between the two modes. This modal dispersion could conceivably be compensated by designing the AWG so that the spectral shift equals the AWG's free spectral range, or a multiple of it. In this way, both modes would image into the same spot at the AWG output, even though they would be operating in different orders in the AWG.

In accordance with another aspect of the invention disclosed here, innovative design concepts are presented for combining single-mode AWG outputs into multi-mode fibers or waveguides for high power and brightness. The reasons why separating the power into multiple bars may be preferred can be ascribed to relaxed cooling requirements (power distributed in larger area), potentially higher yield from aligning smaller bars (less smile), as well as a higher yield from matching bars to a required AWG wavelength range.

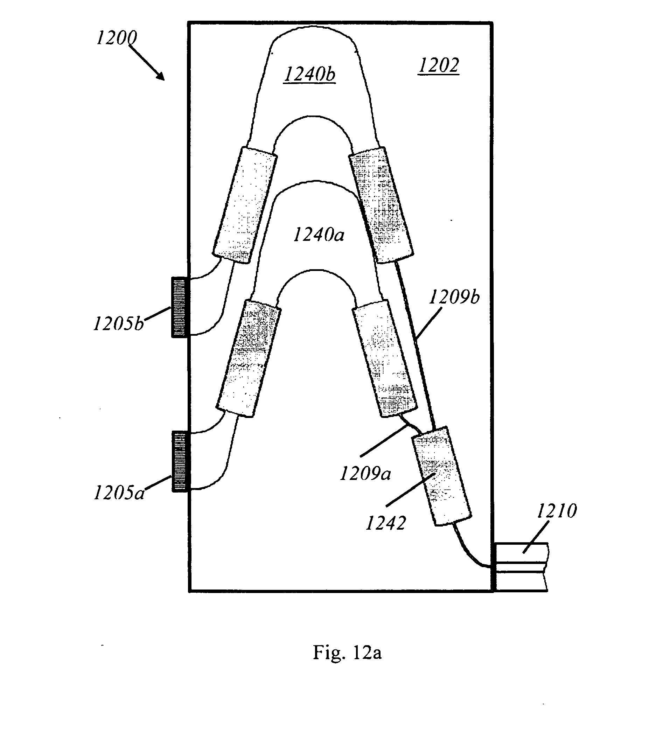

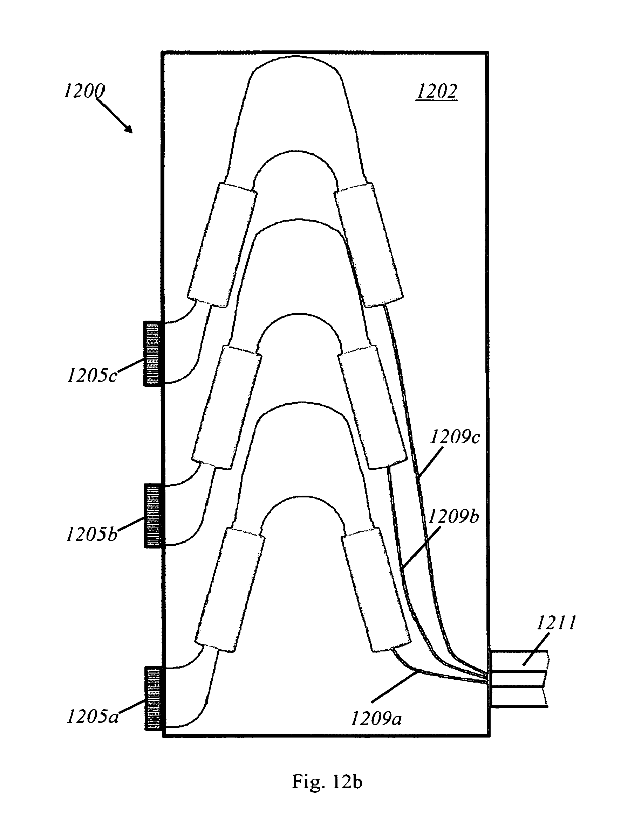

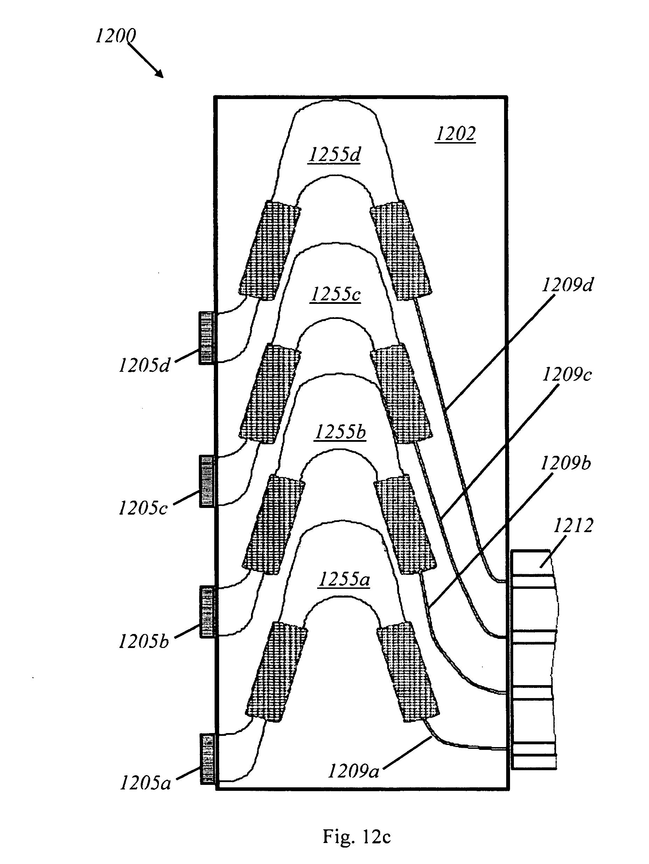

One such concept is to use integrated DAWGs comprising multiple bars and AWGs and combine the power using wavelength multiplexing. This concept is illustrated in Figure 12a, where module **1200** contains two laser diode bars **1205a,b** are coupled into two AWGs **1240a,b** respectively, centered at different wavelengths so that their spectra do not overlap. The optical power in the AWG output single-mode waveguides **1209a,b** is combined in a wavelength combiner **1242** on the PLC chip **1202** such as a Mach-Zehnder interferometer. The output, still in one single-mode waveguide output is suitable for coupling to fiber **1210.**

There are potential advantages to spatially combining narrow single-mode waveguides from a DAWG module into multi-mode fibers. Firstly, single-mode laser diodes are more easily cooled using passive heatsinks or thermo-electric coolers than broad stripe bars, which generally require water cooling. Secondly, single-mode laser diodes can achieve higher power density than multi-mode laser diodes due to absence of multi-mode filaments and non-uniform facet power density. Finally, the inherent mode stability and selectivity of single spatial mode narrow laser stripes may permit better laser performance than multi-mode stripes which can have filaments and non-uniform mode profiles.

Another basic concept is shown in 12b. A series of parallel single-mode laser diode bars **1205a-c** are coupled into a series of AWGs (three only shown in this example) located on AWG chip **1202.** The outputs of single-mode waveguides **1209a-c** are made to converge to an input into a multi-mode fiber 1211. There is a loss of brightness but an increase in total power. The single-mode waveguides **1209a-c** can be aligned spatially (higher total power but uniform power density) or focused together to a spot (higher power density but lower brightness due to different beam angles).

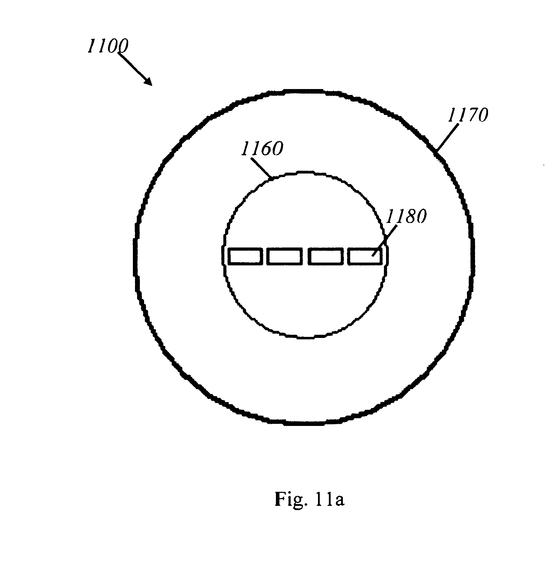

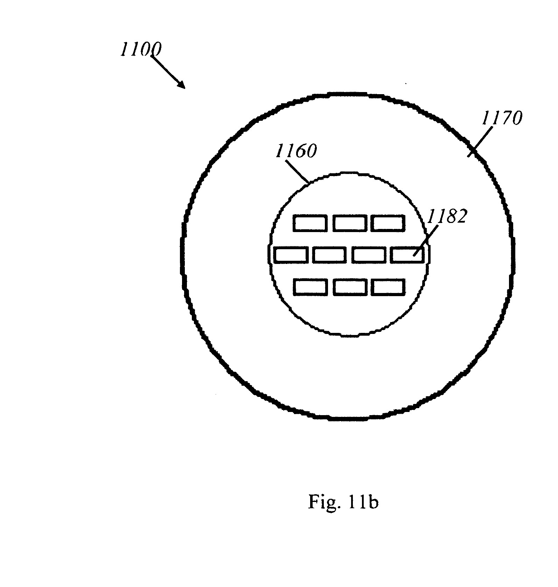

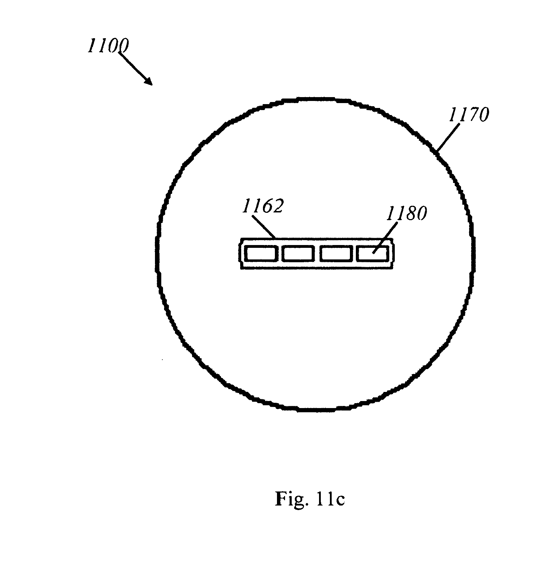

Examples of how single-mode beams combine in multi-mode fiber is shown in Figs. 11a to 11c.

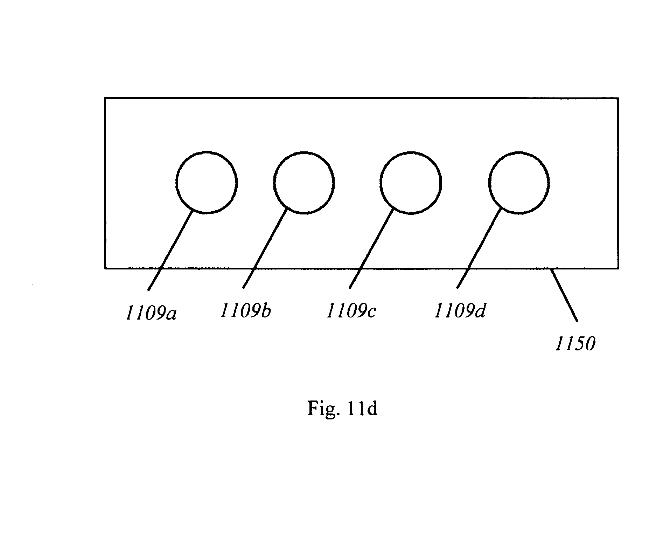

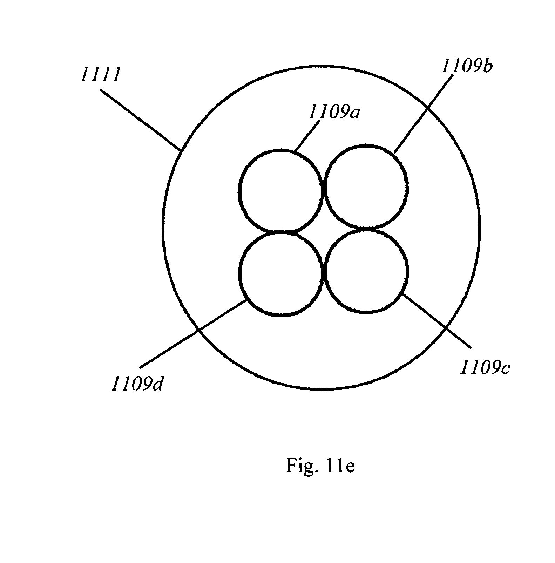

Figure 11 a shows the simplest realization of the concept. A linear array of single mode waveguides **1180** fits spatially in a large core **1160** of multi-mode fiber **1170.** A 2D array **1182,** as illustrated in Fig. 11b, could be used to further fill a core **1160** of fiber **1170** either by stacking AWG outputs, combining AWG outputs using turning mirrors or by fusing rectangular core fiber. Figure 11c shows a concept where a linear array of single mode waveguides **1180** from the AWG output is aligned to a matching rectangular core **1162** of fiber **1170** thereby increasing brightness.

Another possible concept is detailed in 12c. Emission from laser diode chips **1205a-d** of laser system **1200** is collected by silica AWGs **1255a-d** and output on single mode waveguides **1209a-d** respectively, which are directed into a linear array **1212** of single mode fibers. The linear array of fibers **1109a-d** seen in end view in Fig. 11d is aligned in a suitable support **1150** such as a silicon optical bench. The other end of fibers **1109a-d** can then be bundled together to form an end view as seen in Fig. 11e to conserve some of the brightness compared with a similar dimension high numerical aperture multi-mode fiber **1111.** Once bundled, the high power output can be coupled into or fused with a multi-mode fiber or the power can be used directly.

The final concept is an extension of the last method. Separate DAWG modules can be coupled individually into single mode fibers. These separate single-mode fibers can be bundled as in Fig. 11e.

Now an aspect of the invention disclosed will be considered. By combining the outputs of narrow wavelength range DAWG modules with wavelength selective filters, kilowatt levels of optical power can be multiplexed into narrow wavelength bands with superior beam quality and minimum loss of total brightness. The wideband, flat transmission and reflection characteristics of the thin film filters (TFF) are critical for combining the DAWG outputs.

The JDSU concept to achieve a kilowatt level system with a narrow wavelength, diffraction limited beam is based upon passive wavelength combination of high power, single-mode laser diodes. The system output consists of co-linear, co-propagating, wavelength-multiplexed single spatial mode beams that fill the output aperture. This approach obviates the need for complex active phase control of sub-beams to create a coherently coupled spatial array.

This novel approach is enabled by:

a) High power, high efficiency single-mode laser diode arrays;
b) Silica based planar light-wave circuits (PLCs); and
c) Wavelength division multiplexing beam combiners using thin film interference filters.

There are many parameters that must be optimized to a given set of system requirements. An example 5kW 10nm bandwidth system is given in Table 1.

Table 1 : Design targets to meet an example 5kW in 10nm system

| Category | Parameter | Example 5kW Design |
|---|---|---|
| System Requirements | Total System Power (kW) | 5.0 |
| | System Wavelength Range (nm) | 10 |
| | Beam Propagation Factor (BPF) | 0.60 |
| Laser Diode Bar | Center Wavelength (nm) | 975 |
| | Power per Laser Diode (W) | 10 |
| | Laser Diode Efficiency (PCE) | 65% |
| D-AWG Module | Diodes per Bar and AWG | 30 |
| | DAWG Wavelegth Spacing (GHz) | 2.0 |
| | Diode to AWG Efficiency | 65% |
| | Power per AWG Module (W) | 195 |
| | DAWG modules per polarization | 16 |
| | Total number of DAWG Modules | 32 |
| WDM Beam Combiner | Polarization Mulitplexing | 2 |
| | Level 1 Wavelength Channels | 4 |
| | Level 2 Wavelength Channels | 4 |
| | AWG Module Range (GHz) | 60 |
| | Total Wavelength Range (GHz) | 3189 |
| | Wavelength Fill Factor (Light : Total) | 1.0 : 3.3 |
| | Beam Combiner Efficiency | 80% |

The laser diode design is targeted to produce a high power single-mode device. For this example the diodes reach 10W. Previous experience in flares and high-efficiency bars indicate this is difficult but potentially achievable. A shortfall in diode power can be compensated by tighter spacing of the AWGs or WDMBC filters.

For the example, the DAWG combination is targeted to be a 30 channel device with a 2GHz channel spacing operating up to 70% optical efficiency and emitting over 200W in a single-mode aperture. The 2GHz designs have been modeled and are feasible using existing capabilities. The tightest feasible spacing (around 1.5 GHz) is limited by the available 200mm wafer size. The 65% optical efficiency is also challenging but achievable. 200W in a single-mode silica waveguide and fiber is below the theoretical damage threshold limit.

The beam combiner in the example has three levels, including one polarization and two wavelength levels. To evaluate beam quality a Beam Propagation Factor (BPF) is defined as the laser optical output power in a specified far-field bucket divided by the total optical output power radiating from the defining near-field exit aperture of the combined laser beam. The far field bucket is defined as 1.44 times the diffraction-limited spot area defined as

$$(\pi/4)(\theta_{DL}\,f)^2, \text{ where } \theta_{DL} = 2.44\lambda/D$$

where $\lambda$ is the laser center wavelength, f is the focal length of the optics used to form the far field spot, and D is the defining exit aperture of the combined laser beam.

For this example the BPF was targeted at 0.60 which is a useful number for many applications. This number is attainable because the beam combiner inputs are all circular single-mode polarized beams directly from single-mode fiber or collimated AWG output and there are no intentionally beam-aberrating elements in the design. However, the requirements and tolerances on the beam combiner optical components are fairly stringent.

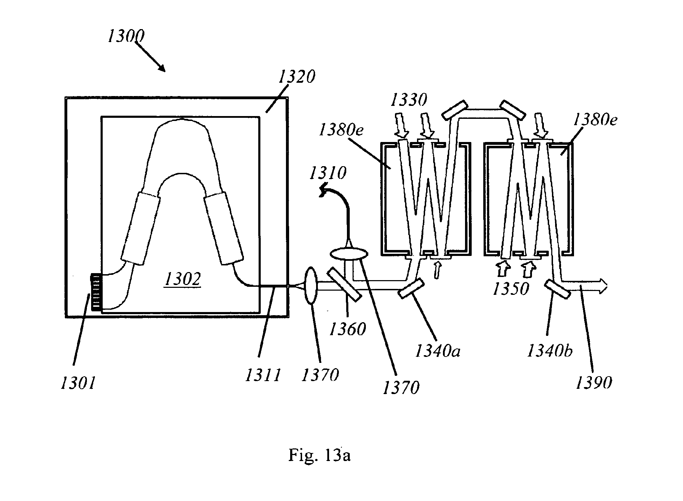

The system architecture concept is shown in Fig. 13a. First, a high power, high efficiency laser diode bar **1301** is coupled into a PLC-based AWG **1302**. The AWG controls the wavelength of each emitter extremely precisely and combines them into one single spatial mode output. The PLC-based AWG **1302** also provides an integration platform that enables novel emitter architectures that scale to multiple watts per emitter.

Next, the output of AWG **1302** is coupled out via output fiber **1311** into collimating and beam expanding optics **1370,** passing on to polarization beamsplitter **1360** to be combined with another output from a similar similar module at orthogonal polarization. The polarization combined beam is then deflected by a turning mirror **1340a** into a second level wavelength division multiplexing beam combiner (WDMBC) **1380a.** The WDMBC **1380a** combines this beam with other similar ones **1330** using thin film interference filters (TFFs). TFFs can combine these narrow wavelength bands efficiently to build up to the kilowatt level within a tight wavelength range. The output of WDMBC **1380a** is input into a third level WDMBC **1380e** with the aid of turning mirrors. This input is further combined with other beams **1350** and finally the aggregate optical power **1390** is output.

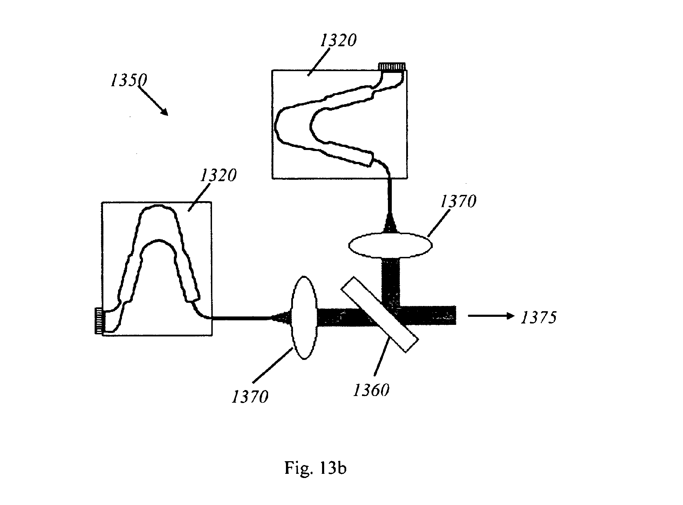

As mentioned above, the first level of a three level beam combiner is polarization multiplexing. Fig. 13b depicts a concept for such a polarization multiplexer **1350**. Output beams of two DAWGs **1320** are collimated and expanded in the optics **1370** before being combined with orthogonal polarizations in the polarization beamsplitter **1360** to produce a combined output beam **1375.**

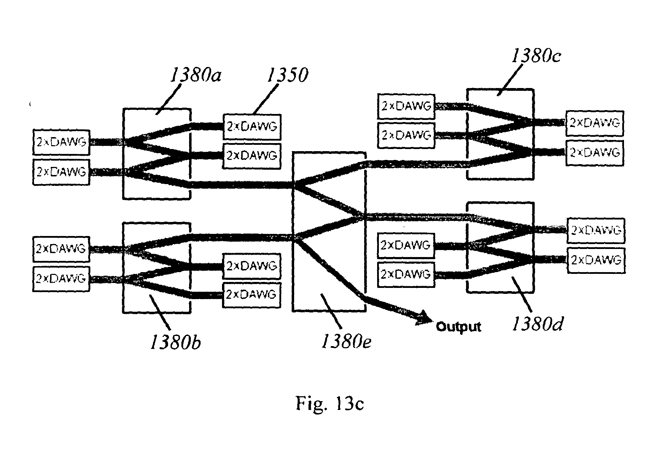

Fig. 13c shows a schematic of an exemplary 5 kW system and its components. The example system uses 32 DAWG modules combined in pairs via polarization multiplex into sixteen modules **1350** (only one referenced as example), which are further combined by five wavelength multiplexing modules **1380a-e.** At three ports of each wavelength multiplexing module **1380a-e** is a wavelength selective TFF, with a total of 15 TFFs required for the system. The maximum number of reflections for any beam off a polarization- or wavelength-selective optical element is seven, the minimum is zero, and the average is 3½. These design choices will change depending on the exact power level and bandwidth requirements.

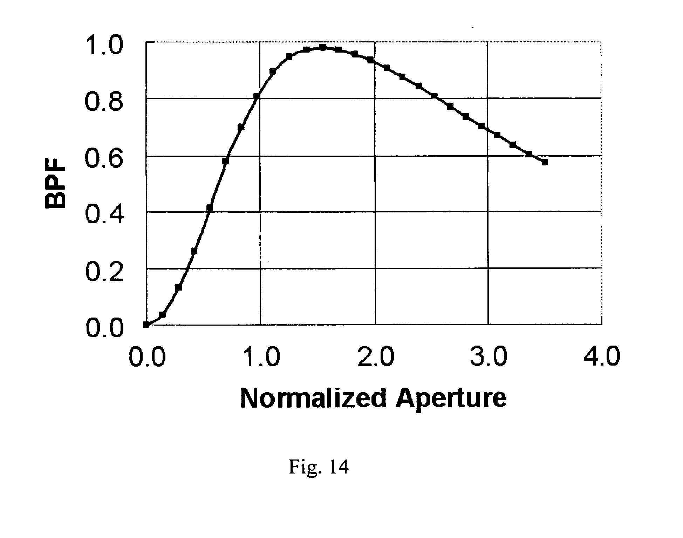

The proposed WDMBC approach provides the specified beam propagation factor (BPF) of 0.60 without stringent requirement on phase matching of individual sub-beams. This passive solution minimizes complexity and enhances robustness. The effects of near-field fill factor, tilt, curvature, and phase ripple can be modeled and trade-offs can be made to establish initial beam quality budgets. The variation of BPF to relative near-field aperture is illustrated in Fig. 14 and the ideal BPF maximizes at 0.98 for an aperture of 1.5 times the beam waist, $w_0$. A smaller near-field aperture clips the beam and adds diffraction losses, while larger size reduces the size of the far-field bucket and the fraction collected.

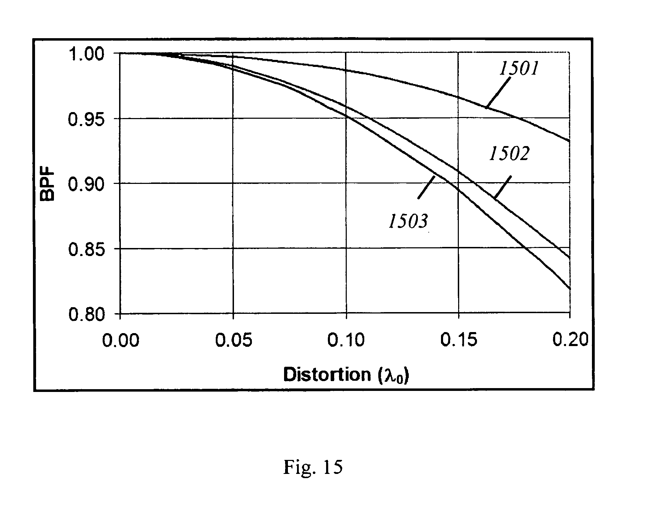

The AWG modules deliver single spatial mode power via single-mode fibers (or in free-space) to the beam combiner. Each beam experiences a number of bounces through the beam combiner which adds tilts, curvatures, and phase ripple to the combined output beam. Aberrations that degrade the beam quality and BPF have been budgeted using a propagation model as summarized in the plots of Figs. 15 for an aperture 1.5 times the beam waist respectively, where the effects of tilt **1501,** curvature **1502,** and phase ripple **1503** (8-cycle sinusoidal) on the BPF are plotted as functions of magnitude. It is reasonable to assume that these aberrations are random and uncorrelated so that the output wave-front errors are proportional to the square root of the number of bounces. These design curves enable estimation of a preliminary wave-front error budget, per beam combiner optical element.

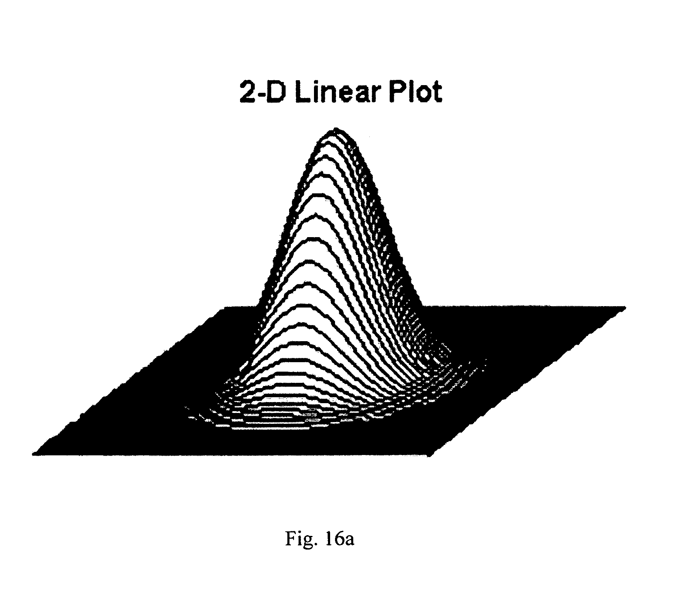

The near-field beam of the system is a Gaussian filling the near-field aperture as shown in Fig. 16a, where the aperture size is related to the $1/e^2$ beam waist, $w_0$. The ideal beam propagation factor (BPF) maximizes at 0.98 for an aperture of $1.5w_0$. By including acceptable non-idealities in the optical system a 0.60 BPF is possible.

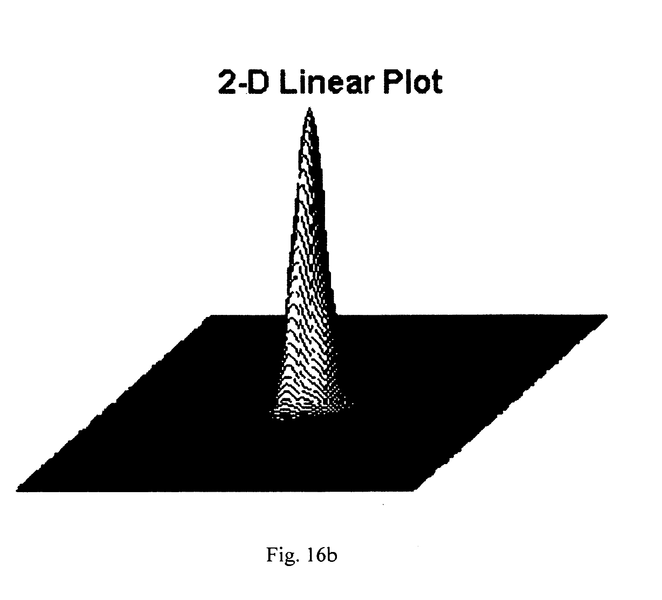

An example modeled far-field of a combined beam is shown in Fig. 16b, including aberrations, where BPF = 0.60. The asymmetry is due to random optical aberrations (tilt, curvature and phase ripple). The aberrations are a result of beam misalignment, optics imperfections and thermally induced effects.

In summary, beam combination via wavelength multiplexing leads to achievable optical tolerances and eliminates the need for complex, active phase control, making it possible to meet the BPF requirements of this system.

As mentioned before, the collimated output of the DAWG modules is combined using a series of polarization and wavelength beam combiners. These will now be considered in more detail.

The beam combining system collimates the DAWG output beams using a lens system. To keep the power per unit area to a reasonable level the beam will be expanded to dimensions on the order of millimeters. The target power density is less than several hundred W/cm$^2$ at the collimation stage which is low enough to permit the use of a transmission lens (or lenses). The lenses should be adjustable to permit precise beam alignment and adjustment so that the beams from all bands are identical at the output.

The first multiplexing stage is preferably polarization multiplexing for two reasons:

1) the narrow bandwidth at this stage eases the design of the polarizing filters, and 2) it facilitates use of a cube beam combining geometry that does not optically distort the beam.

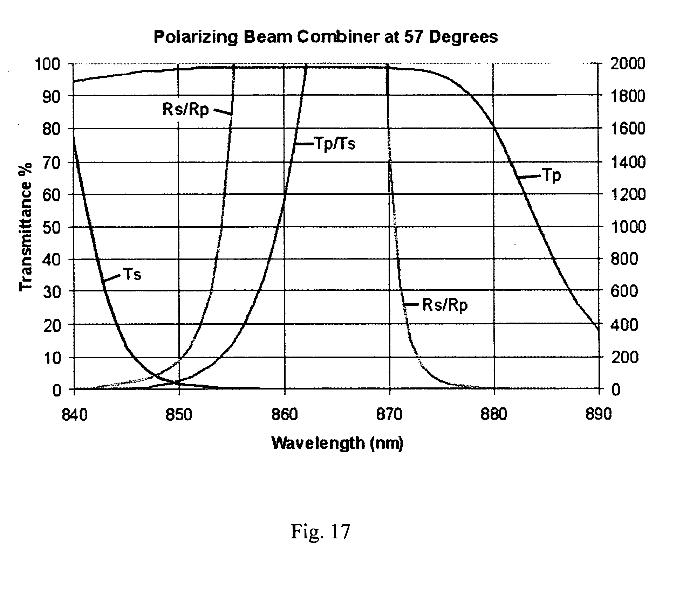

A thin-film based polarization multiplexer operates by transmitting one polarization through a filter while reflecting the other polarization from the filter, both into a common beam. The polarization multiplexer may be a single plate. In this case it may be used at an angle of incidence of approximately 60 degrees. The theoretical spectrum of such a polarization combiner is shown in Fig. 17. Another possible implementation would employ a 45 degree air-spaced cube beam splitter, which reduces induced beam aberrations.

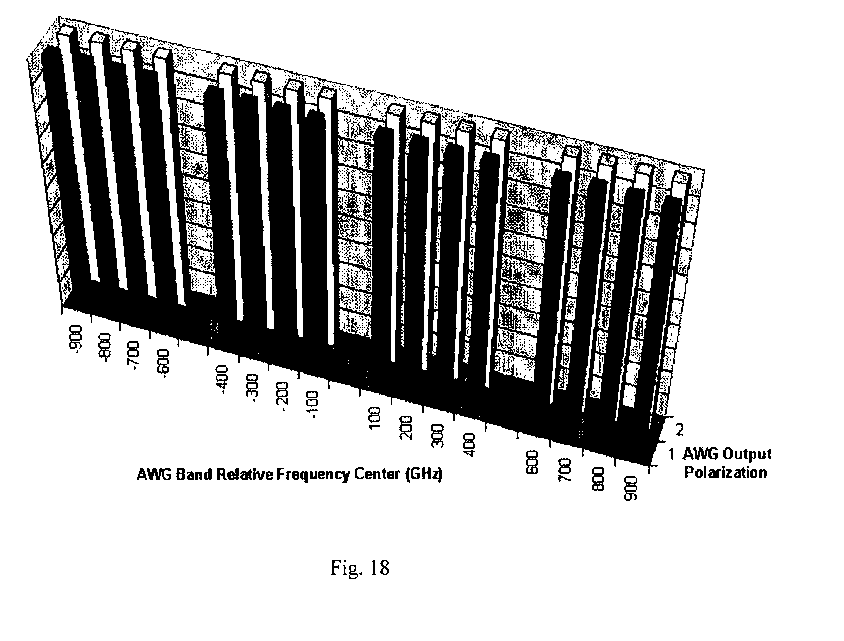

The subsequent multiplexing steps are wavelength multiplexing. After polarization combining, the outputs from the N AWGs is then in the form of N/2 beams, each of the beams charaterized by a distinct wavelength band as shown schematically in Fig. 18 for an examplary system with N=32 DAWG modules.

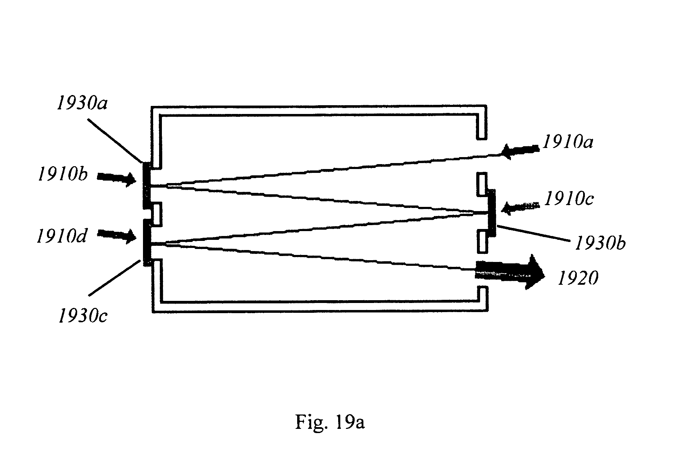

By using multiple levels of multiplexing, power in the kilowatt range can be achieved. In one possible implementation, each level employs a zigzag multiplexer of the type shown in Fig. 19a. In wavelength multiplexer **1940,** AWG bands 1-4, indicated by **1910a-d** respectively, are reflected in turn from TFFs **1930a, 1930b** and finally **1930c,** the combined beam exiting at port **1920.**

Another possible implementation using two levels of wavelength multiplexing will first combine DAWG Modules outputs in groups of four wavelength bands (Level 1 bands) and then to combine four such bands into a final output (Level 2 bands).

The exact geometry will be arrived at through trade-offs of filter performance, power-handling capability of filters, small device size, etc.

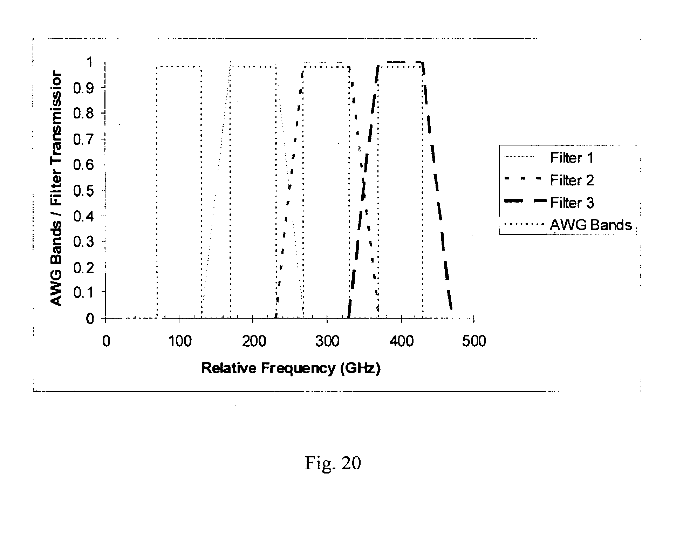

In the 5kW example of a Level 1 multiplexer, the filters must transmit a 60 GHz AWG band while reflecting one or more of the other AWG bands. The transition region between bands can be 40 GHz. A plot illustrating Level 1 multiplexing is given in Fig. 20. Filter 1 reflects AWG Band 1 (centered at 100 GHz relative frequency), while transmitting AWG band 2 (centered at 200 GHz relative frequency). Filter 2 transmits AWG band 3, while reflecting bands 1 and 2. Similarly Filter 3 adds AWG band 4 into the beam.

Filters of this type are commonly fabricated for telecommunications applications in the 1550-nm wavelength region, commonly having dimensions of 1-2 mm on a side. For high-power applications, the filters must be scaled up in size to have a clear aperture (having uniform coating performance) of 20-25 mm, and in total power-handling capability from a few Watts to a few kilowatts. Level one multiplexing filters need to handle about 500 W in transmission, and up to about 1500 W in reflection.

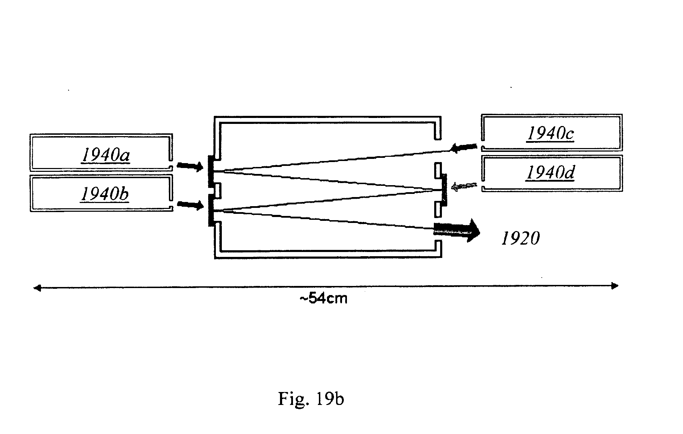

The outputs of four Level 1 devices **1940a-d** can be multiplexed using another zigzag multiplexer of the type shown in Fig. 19b to produce a combined beam **1925.** A geometrical arrangement may provide for the Level 1 zigzag paths to be orthogonal to the zigzag path of the Level 2 multiplexer. If such a scheme is employed, the space occupied by four Level 1 multiplexers and one Level 2 multiplexer would be on the order of 540 mm x 180 mm x 120 mm. Fig. 19b shows the Level 2 multiplexer with outlines of the four Level 1 multiplexers.

The Level 1 bands consist of four channels and three dead-spaces totaling 360 GHz. The Level 2 filters therefore must combine the 360 GHz bands. The dead-space between Level 1 bands is preferably 140 GHz. By using several zigzags instead of just one, the total number of reflections may be reduced as compared with using a single large zigzag. This decreases the amount of beam distortion introduced, and therefore should improve beam quality. In the disclosed architecture, the worst-case beam undergoes 7 reflections: one in the polarization multiplexer, three in the Level 1 multiplexer, and three in the Level 2 multiplexer. This compares with 16 for the worst case beam if a single zigzag combiner is used: one in the polarization multiplexer, 15 in the zigzag multiplexer.

Several families of products are expected to be enabled by the laser diode coupled AWG (DAWG) technology.

The most straightforward products derived from the DAWG are potentially high-power single-mode fiber-coupled (FC) modules. These products could be direct replacements for today's commercially available CW fiber lasers (FLs). They would bring the advantages of wavelength versatility (most FL's are based on Yb at 1050-1100nm), compactness, improved efficiency, and enhanced reliability due to the elimination of double-clad fiber.

A second family of products would be a multimode implementation of the DAWG in which broad-area emitters are spectrally multiplexed to provide output powers in the 100W range from a 25-100 micron core fiber. Lifting the constraint of single-mode operation can make such devices smaller, cheaper, and more manufacturable than the single-mode version. They would still have much higher brightness than conventional multimode FC bars and would address many applications now being served by fiber lasers. For applications demanding pulsed output or extremely high brightness, they would serve as a very cost-effective pump for Yb fiber lasers or disk lasers. One particular area of interest would be as a pump source for amplifying picosecond or femtosecond pulses in double-clad fiber, where the fiber length must be kept extremely short to mitigate pulse distortion, for which a very high brightness pump is advantageous. The multimode DAWG may be a key technology that enables commercially viable, high-average-power ultrashort-pulse sources.

The narrow wavelength high brightness pump technology can improve fiber laser efficiency in a number of ways. Firstly, the tight wavelength control makes them suitable for optical pumping of the narrow 976nm Ytterbium line which has a better quantum defect and higher absorption than the broader 915nm line. Secondly, the high brightness permits pumping into a smaller diameter fiber. Conventional bars and single emitters, with relatively low brightness, require a large inner cladding (typically 400-600 microns in diameter) and a high-NA polymer outer clad fiber, which ends up being very long (typically >50m) with a much higher loss per unit length. Thirdly, the combination of these improvements translates to a shorter overall fiber length with lower overall absorption and scattering and lower threshold power requirements. Fourthly, these changes will support lasing in the 1040nm band which has a lower quantum defect. For example the impact of pumping at 976nm and lasing at 1050nm, versus 915nm and 1100nm, is to improve the quantum defect from 83% to 93%. The net effect of these improvements can enable a fiber laser optical-to-optical efficiency in the 80% range.

Finally spectral multiplexing of either the single-mode or the multimode DAWG modules will enable reaching higher output powers without impacting beam quality. For example, it will be possible to spectrally MUX a number of multimode DAWGs to create a 2-5kW industrial cutting/welding direct diode solution that would be extremely reliable and cost-effective. This could be an appealing alternative to current FL-based architectures being explored, in which a number of 100-200W single-mode fiber lasers are combined spatially into a multimode output.

The DAWG module is interesting for breakthrough products in a variety of markets. Single mode DAWGs can replace fiber lasers for non-metal marking, drilling and other material processing applications. Multi mode DAWGs can also serve low brightness material processing applications. Furthermore multi-mode (or single-mode) DAWGs can be spatially or spectrally combined to reach the kilowatt level metal material processing market. Finally DAWGs will enable more efficient, higher brightness, higher power fiber lasers.

**Claims**

1. A high power laser source comprising:

   a first chip including a multi-mode semiconductor waveguide for providing gain in a predetermined wavelength band, wherein each semiconductor waveguide has a first reflector at one end;
   a second chip including an array waveguide grating having an input port coupled to the semiconductor waveguide, and an output port;
   a second reflector disposed to receive light from the array waveguide grating output port and to reflect a portion of the light back into the array waveguide grating, thereby defining a laser cavity with the first reflector;

   wherein:

   the semiconductor waveguide is dimensioned to support propagation of multiple transverse modes of light having wavelengths in the predetermined wavelength band; and the multiple transverse modes on the first chip are optically coupled to the input port of the array waveguide grating on the second chip.

2. The high power laser source in claim 1, further comprising additional semiconductor waveguides, wherein spaces between the semiconductor waveguides are not uniform in order to obtain a prescribed temperature gradient across the first chip.

3. The high power laser source in claim 2, wherein the prescribed temperature gradient is constant.

4. The high power laser source in claim 2, wherein the prescribed temperature gradient is approximately zero.

5. The high power laser source in claim 1, further comprising coupling means for coupling the semiconductor waveguide to the array waveguide grating, wherein the coupling means is selected from the group consisting of a planar lens, a cylindrical lens, a two-dimensional lens, a multi-mode interference region, an integrated fast-axis lens etched into the first chip, and an integrated fast-axis lens etched into the second chip.

6. The high power laser source in claim 1, wherein the second reflector is located proximate to the output port of the array waveguide grating.

7. The high power laser source in claim 1, wherein the second reflector is located in an output optical fiber which is coupled to the output port of the array waveguide grating.

8. The high power laser source in claim 1, further comprising coupling means for coupling the semiconductor waveguide to the array waveguide grating, wherein the coupling means comprises a planar grin lens integrated in the input port of the array waveguide grating.

9. The high power laser source in claim 1, wherein the semiconductor waveguide has a flare increasing in width toward the input port of the array waveguide grating.

10. The high power laser source in claim 9, wherein the flares overlap to form a contiguous region at the input port of the array waveguide grating.

11. The high power laser source in claim 1, wherein the semiconductor waveguide is optically coupled to a star-coupler region of the input port of the array waveguide grating.

12. The high power laser source in claim 1, wherein the output port of the array waveguide grating comprises a single-mode output waveguide.

13. The high power laser source in claim 1, wherein the input port of the array waveguide grating comprises a slab waveguide.

14. The high power laser source in claim 1, wherein the input port of the array waveguide grating comprises a star-coupler region of an array waveguide grating.

15. The high power laser source in claim 5, wherein the multi-mode interference region supports multiple wavelengths.

16. The high power laser source in claim 1, wherein the output port of the array waveguide grating has a focus outside an edge of the second chip to reduce optical field intensity within the second chip and to provide optical coupling to an optical fiber.

17. The high power laser source according to claim 12, further comprising additional array waveguide gratings, wherein each array waveguide grating transmits therethrough a different wavelength band and the single-mode output waveguides are combined in a wavelength combiner into a single-mode combined output waveguide which is coupled to a single-mode fiber.

18. The high power laser source according to claim 12, further comprising additional array waveguide gratings, wherein each single-mode output waveguide is terminated at an edge of the second chip for coupling to a multi-mode core of a single output fiber.

19. The high power laser source according to claim 18, wherein the single-mode output waveguides form a two-dimensional array at the edge of the second chip.

20. The high power laser source according to claim 18, wherein each single-mode output waveguide is terminated at the edge of the second chip for coupling to a rectangular multi-mode core of a single output fiber.

21. The high power laser source according to claim 12, wherein the single-mode output waveguides are terminated at an edge of the second chip to align with single-mode fibers at a first end of a single-mode fiber array.

22. The high power laser source according to claim 21, wherein a second end of the single-mode fiber array is configured so that the single mode fibers form a two-dimensional array for coupling into a multi-mode core of a single optical fiber.

Prior Art

Fig. 1a

Prior Art

Fig. 1b

Fig. 2a

200

219

250

201

260

201

202

219

210

Fig. 2b

Fig. 3a

Fig. 3b

Fig. 4

Fig. 5a

Fig. 5b

503        527        504

501    507    508    502

Fig. 5c

Fig. 6

700

729a

704a

703a

D

729b

703b

704b

705

707

708

720

729c

704c

W

703c

L

701

702

Fig. 7a

Fig. 7b

Fig. 7c

Fig. 7d

Fig. 7e

Fig. 8

*902*

*985*

*909*

Fig. 9a

Fig. 9b

Fig. 10a

Fig. 10b

Fig. 11a

1100

1170

1160

1182

Fig. 11b

Fig. 11c

1109a    1109b    1109c    1109d

1150

Fig. 11d

Fig. 11e

Fig. 12a

Fig. 12b

1200

1202

1255d

1255c

1255b

1255a

1205d

1205c

1205b

1205a

1209d

1209c

1209b

1212

1209a

Fig. 12c

Fig. 13a

Fig. 13b

Fig. 13c

Fig. 14

Fig. 15

# 2-D Linear Plot

Fig. 16a

Fig. 16b

Fig. 17

Fig. 18

Fig. 19a

1940a

1940b

1940c

1940d

1920

~54cm

Fig. 19b

Fig. 20

**European Patent Office**

## EUROPEAN SEARCH REPORT

Application Number

EP 06 25 5902

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br>A | EP 1 028 333 A2 (FUJIKURA LTD [JP])<br>16 August 2000 (2000-08-16)<br>* paragraphs [0001], [0018], [0019], [0046], [0049], [0067] - [0094], [0145] - [0148]; claim 1; figure 1 *<br>----- | 1,6,11<br><br>7 | INV.<br>H01S5/40<br><br>ADD.<br>H01S5/14 |
| Y | US 2002/085594 A1 (PEZESHKI BARDIA [US] ET AL) 4 July 2002 (2002-07-04)<br>* paragraphs [0054] - [0056]; figure 11 *<br>----- | 1,6,11 | |
| A | US 5 913 000 A (DOERR CHRISTOPHER RICHARD [US] ET AL) 15 June 1999 (1999-06-15)<br>* column 2, lines 26-65; figure 1 *<br>----- | 1,6,11 | |
| A | US 6 055 250 A (DOERR CHRISTOPHER RICHARD [US] ET AL) 25 April 2000 (2000-04-25)<br>* column 2, lines 50-56 *<br>* column 2, lines 36-55; claim 1 *<br>----- | 1,6,11 | |
| | | | TECHNICAL FIELDS SEARCHED (IPC)<br><br>H01S |

The present search report has been drawn up for all claims

| Place of search | Date of completion of the search | Examiner |
|---|---|---|
| Munich | 23 January 2007 | Gnugesser, Hermann |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 788 678 A1**

## ANNEX TO THE EUROPEAN SEARCH REPORT
## ON EUROPEAN PATENT APPLICATION NO.

EP 06 25 5902

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2007

| Patent document cited in search report | | Publication date | Patent family member(s) | | Publication date |
|---|---|---|---|---|---|
| EP 1028333 | A2 | 16-08-2000 | DE | 60019658 D1 | 02-06-2005 |
| | | | DE | 60019658 T2 | 24-05-2006 |
| | | | HK | 1027630 A1 | 12-08-2005 |
| | | | JP | 2000232248 A | 22-08-2000 |
| | | | US | 6459829 B1 | 01-10-2002 |
| US 2002085594 | A1 | 04-07-2002 | NONE | | |
| US 5913000 | A | 15-06-1999 | NONE | | |
| US 6055250 | A | 25-04-2000 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020085594 A, Bardia Pezeshki

- US 6212310 B, Robert G. Waarts